# EUROPEAN PATENT SPECIFICATION

(11) **EP 3 906 756 B1**
(45) Date of publication and mention of the grant of the patent: **21.10.2026**
(21) Application number: 19907375.0
(22) Date of filing: 17.12.2019
(51) Int. Cl.: H05K 1/14, H05K 3/325, B60Q 1/00

(54) **SENSOR MODULE**
SENSORMODUL
MODULE DE CAPTEUR

(30) Priority: 03.01.2019 US 201962787769 P
(43) Date of publication of application: 10.11.2021
(73) Proprietor: ZKW Group GmbH, 3250 Wieselburg (AT)
(72) Inventor: CHOI, Yongjoon, Seoul 06772 (KR); PARK, Hyunyeol, Seoul 06772 (KR)
(74) Representative: Patentanwaltskanzlei Matschnig & Forsthuber OG
(86) International application number: PCT/KR2019/017867
(87) International publication number: WO 2020/141761

(56) References cited:
- EP-A2- 1 310 012
- EP-A2- 1 312 935
- WO-A2-2007/033849
- JP-A- 2003 004 448
- KR-A- 20180 103 584
- US-A1- 2009 135 043
- US-A1- 2017 307 724
- US-B1- 6 380 883
- US-B1- 6 501 415

## Description

### Technical Field

The present disclosure relates to a sensor module that can be provided in a vehicle lamp.

### Background Art

A vehicle denotes a means of transporting people or goods using kinetic energy. Representative examples of vehicles include automobiles and motorcycles.

For safety and convenience of a user who uses the vehicle, various sensors and devices are provided in the vehicle, and the functions of the vehicle are diversified.

The function of the vehicle may be divided into a convenience function for promoting the convenience of a driver and a safety function for promoting the safety of a driver and/or a pedestrian.

First, the convenience function has a motive for development related to driver convenience, such as giving an infotainment (information + entertainment) function to the vehicle, supporting a partial autonomous driving function, or assisting the driver's vision such as night vision or blind spot. For example, the convenience function may include an active cruise control (ACC) function, a smart parking assist system (SPAS) function, a night vision (NV) function, a head up display (HUD) function, an around view monitor (AVM) function, and an adaptive headlight system (AHS) function, and the like.

The safety function is a technology for securing the safety of the driver and/or the safety of a pedestrian, and may include a lane departure warning system (LDWS) function, a lane keeping assist system (LKAS) function, an autonomous emergency braking (AEB) function, and the like.

For convenience of a user using a vehicle, various types of sensors and electronic devices are provided in the vehicle. In particular, for the convenience of the user's driving, research on an advanced driver assistance system (ADAS) is being actively carried out. Furthermore, development of an autonomous vehicle is being actively carried out.

As the development of such autonomous vehicles is actively carried out, various developments related to a sensor module for sensing information required for autonomous driving have been carried out. For an example, technology development on which part of the vehicle the relevant sensor module is to be disposed and on which type of the sensor module is to be defined has been actively carried out.

Patent application EP1310012A2 discloses a sensor system including two printed circuit boards that are mounted to face each other, a housing that covers these printed circuit boards and an EMI shield that is disposed under the second printed circuit board.

### Disclosure of Invention

### Technical Problem

The present disclosure is contrived to solve the foregoing problems and other problems.

One aspect of the present disclosure is to provide a sensor module disposed at a portion of a lamp provided in a vehicle.

Another aspect of the present disclosure is to provide a sensor module optimized to be disposed at a portion of a vehicle lamp.

Still another aspect of the present disclosure is to provide a sensor module provided in a rear lamp of a vehicle, and configured to minimize an area occupied by the rear lamp.

### Solution to Problem

According to the invention, a sensor module is provided according to claim 1.

It may be provided that, the first printed circuit board may be provided with an antenna unit, and the second printed circuit board may be provided with a signal processor, a communication unit and a power supply unit.

It may be provided that, the antenna unit provided in the first printed circuit board may transmit a radar signal under the control of the signal processor, and receive a radar signal from the outside, and the signal processor provided in the second printed circuit board may control a signal to be transmitted from the antenna unit, and process a signal received through the antenna unit, and the communication unit provided in the second printed circuit board may transmit the signal processed by the signal processor to an ADAS system provided in a vehicle.

It may be provided that, the sensor module may further include a first connector electrically connecting the first printed circuit board and the second printed circuit board.

It may be provided that, the first connector may be disposed in a flexible manner.

It may be provided that, the second printed circuit board may be disposed to have a larger area than that of the first printed circuit board.

The second printed circuit board includes the first region overlapping with one surface of the first printed circuit board in a direction facing the first printed circuit board; and the second region surrounding the first region, wherein the at least one hole is disposed in the second region.

It may be provided that, the first support portion may be disposed to transmit and receive electrical signals, and the first printed circuit board and the second printed circuit board may transmit and receive electrical signals through the first support portion.

It may be provided that, a second support portion may be further provided on the other surface of the second printed circuit board, and a lamp module of a vehicle may be coupled thereto through the second support portion.

It may be provided that, the first printed circuit board may be provided with an antenna unit, a signal processor and a communication unit, and the second printed circuit board may be provided with a power supply unit.

It may be provided that, the first printed circuit board may be provided with an antenna unit and a signal processor, and the second printed circuit board may be provided with a communication unit and a power supply unit.

It may be provided that, a third printed circuit board disposed to face the second printed circuit board, and spaced apart by a second predetermined distance in the one side direction of the second printed circuit board; and a second support portion connecting the second printed circuit board and the third printed circuit board to be spaced apart from each other, wherein the first through third printed circuit boards are provided with an antenna unit, a signal processor, a communication unit and a power supply unit.

It may be provided that, the first printed circuit board may be provided with an antenna unit, and the second printed circuit board may be provided with a signal processor, and the third printed circuit board may be provided with a communication unit and a power supply unit.

It may be provided that, the antenna unit provided in the first printed circuit board may transmit a radar signal under the control of the signal processor, and receive a radar signal from the outside, and the signal processor provided in the second printed circuit board may control a signal to be transmitted from the antenna unit, and process a signal received through the antenna unit, and the communication unit provided in the third printed circuit board may transmit the signal processed by the signal processor to an ADAS system provided in a vehicle.

It may be provided that, the sensor module may further include a first connector electrically connecting the first printed circuit board and the second printed circuit board; and a second connector electrically connecting the second printed circuit board and the third printed circuit board.

It may be provided that, the first connector and the second connector may be disposed in a flexible manner.

It may be provided that, the first printed circuit board and the third printed circuit board may be disposed to have the same area, and the first printed circuit board and the third printed circuit board may be disposed to overlap with each other in directions facing each other.

It may be provided that, the second printed circuit board may be disposed to have a larger area than that of the first and third printed circuit boards.

The at least one hole is disposed in a region of the second printed circuit board that does not overlap with the first and third printed circuit boards.

It may be provided that, the second printed circuit board may include a first region overlapping with one surface of the first printed circuit board in a direction facing the first printed circuit board; and a second region surrounding the first region, wherein at least one hole is disposed in the second region.

It may be provided that, the first support portion and the second support may be disposed to transmit and receive electrical signals, and the first printed circuit board and the second printed circuit board may transmit and receive electrical signals through the first support portion, and the second printed circuit board and the third printed circuit board may transmit and receive electrical signals through the second support portion.

It may be provided that, a third support portion may be further provided on the other surface of the third printed circuit board, and a lamp module of a vehicle may be coupled thereto through the third support portion.

It may be provided that, the first printed circuit board may be provided with an antenna unit, and the second printed circuit board may be provided with a signal processor and a communication unit, and the third printed circuit board may be provided with a power supply unit.

It may be provided that, the first printed circuit board may be provided with an antenna unit and a signal processor, and the second printed circuit board may be provided with a communication unit, and the third printed circuit board may be provided with a power supply unit.

It may be provided that, the first printed circuit board may be provided with an antenna unit and a signal processor, and the second printed circuit board may be provided with a power supply unit, and the third printed circuit board may be provided with a communication unit.

### Advantageous Effects of Invention

The effects of a path providing device and a path providing method thereof according to the present disclosure will be described as follows.

First, the present disclosure provides a new sensor module that can be mounted on a portion of a vehicle lamp.

Second, the present disclosure provides a sensor module that can be mounted on the minimum area of the vehicle lamp.

Third, the present disclosure provides a plurality of printed circuit boards (or layers, or PCBs) overlapping with each other, and components included in the sensor module may be distributively arranged on each printed circuit board, thereby minimizing an area occupied by the sensor module in the vehicle lamp.

### Brief Description of Drawings

FIG. 1 is a view illustrating an appearance of a vehicle.
FIG. 2 is a view in which a vehicle is viewed at various angles from the outside.
FIGS. 3 and 4 are views illustrating an inside of a vehicle.
FIGS. 5 and 6 are views referenced to describe objects of the present disclosure.
FIG. 7 is a block diagram referenced to describe a vehicle.
FIG. 8 is a conceptual view for explaining a vehicle lamp and the position of a sensor module provided therein.
FIG. 9 is a conceptual view for explaining a sensor module that is used in an embodiment of the present disclosure.
FIGS. 10A and 10B are conceptual views for explaining the structures of a case where a sensor module consists of two printed circuit boards and a case where the sensor module consists of three printed circuit boards.
FIGS. 11A and 11B are conceptual views for explaining an example in which a support portion and a connector are integrally formed.
FIG. 12 is a conceptual view for explaining a cover and an electromagnetic wave absorber provided in the sensor module of the present disclosure.
FIG. 13 is a conceptual view for explaining the position where the sensor module of the present disclosure is provided in the vehicle lamp.
FIG. 14 is a conceptual view for explaining an outer lens applicable to a case where the sensor module of the present disclosure is provided in the vehicle lamp.

### Mode for the Invention

Hereinafter, the embodiments disclosed herein will be described in detail with reference to the accompanying drawings, and the same or similar elements are designated with the same numeral references regardless of the numerals in the drawings and their redundant description will be omitted. A suffix "module" and "unit" used for constituent elements disclosed in the following description is merely intended for easy description of the specification, and the suffix itself does not give any special meaning or function. In describing the embodiments disclosed herein, moreover, the detailed description will be omitted when specific description for publicly known technologies to which the invention pertains is judged to obscure the gist of the present invention. The accompanying drawings are used to help easily understand various technical features and it should be understood that the embodiments presented herein are not limited by the accompanying drawings. As such, the present disclosure should be construed to extend to any alterations, equivalents and substitutes in addition to those which are particularly set out in the accompanying drawings. The scope of the invention is defined by the appended claims.

It will be understood that although the terms first, second, etc. may be used herein to describe various elements, these elements should not be limited by these terms. These terms are generally only used to distinguish one element from another.

It will be understood that when an element is referred to as being "connected with" another element, the element can be connected with the other element or intervening elements may also be present. In contrast, when an element is referred to as being "directly connected with" another element, there are no intervening elements present.

A singular representation may include a plural representation unless it represents a definitely different meaning from the context.

Terms "include" or "has" used herein should be understood that they are intended to indicate the existence of a feature, a number, a step, a constituent element, a component or a combination thereof disclosed in the specification, and it may also be understood that the existence or additional possibility of one or more other features, numbers, steps, constituent elements, components or combinations thereof are not excluded in advance.

A vehicle may be understood as a conception including cars, motorcycles and the like. Hereinafter, the vehicle will be described based on a car.

The vehicle may be a conception including all of an internal combustion engine car having an engine as a power source, a hybrid vehicle having an engine and an electric motor as power sources, an electric vehicle having an electric motor as a power source, and the like.

In the following description, a left side of a vehicle refers to a left side in a driving direction of the vehicle, and a right side of the vehicle refers to a right side in the driving direction.

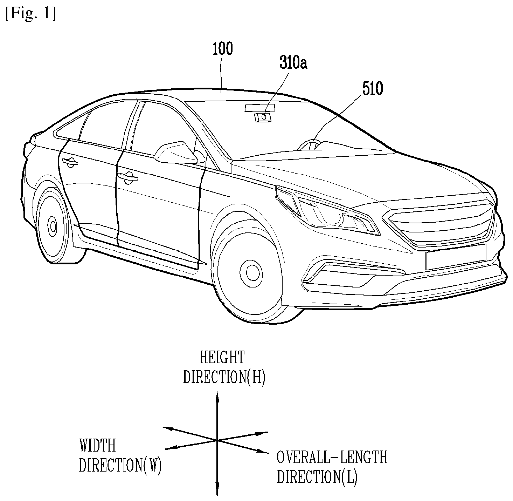

FIG. 1 is a view illustrating an appearance of a vehicle.

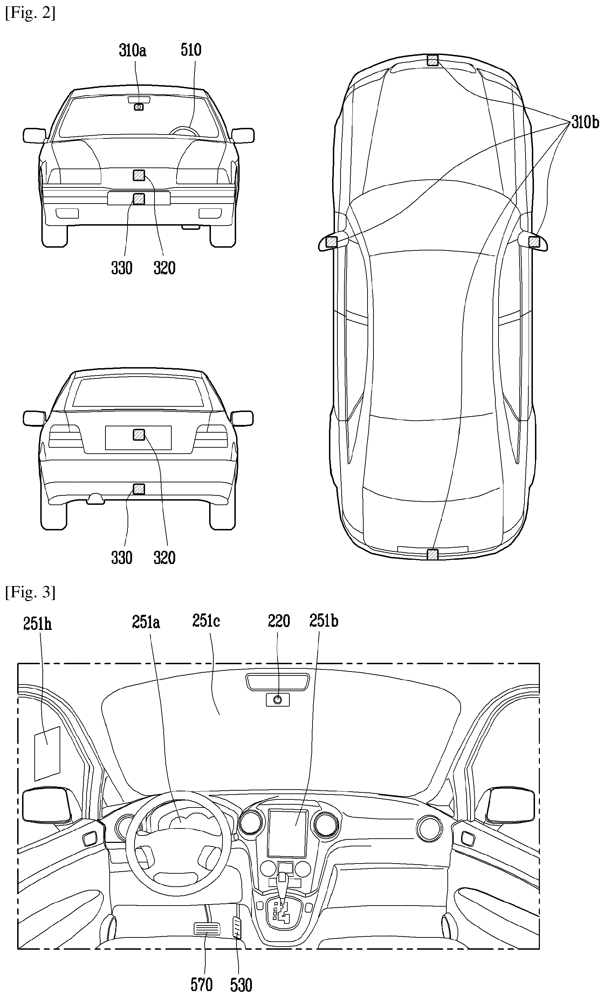

FIG. 2 is a view in which a vehicle is viewed at various angles from the outside.

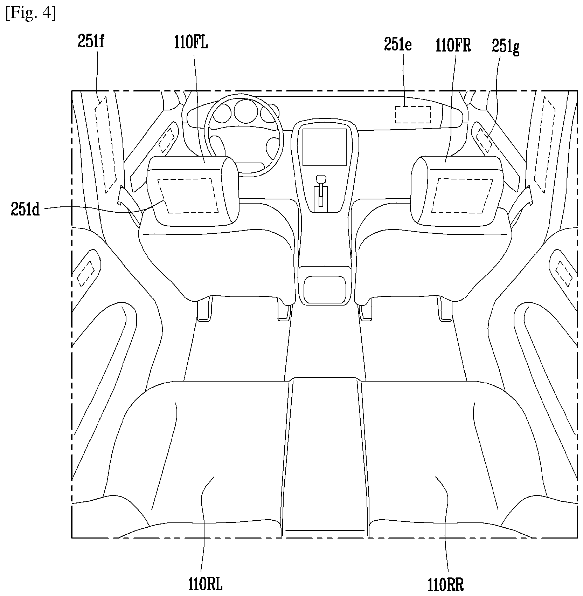

FIGS. 3 and 4 are views illustrating an inside of a vehicle.

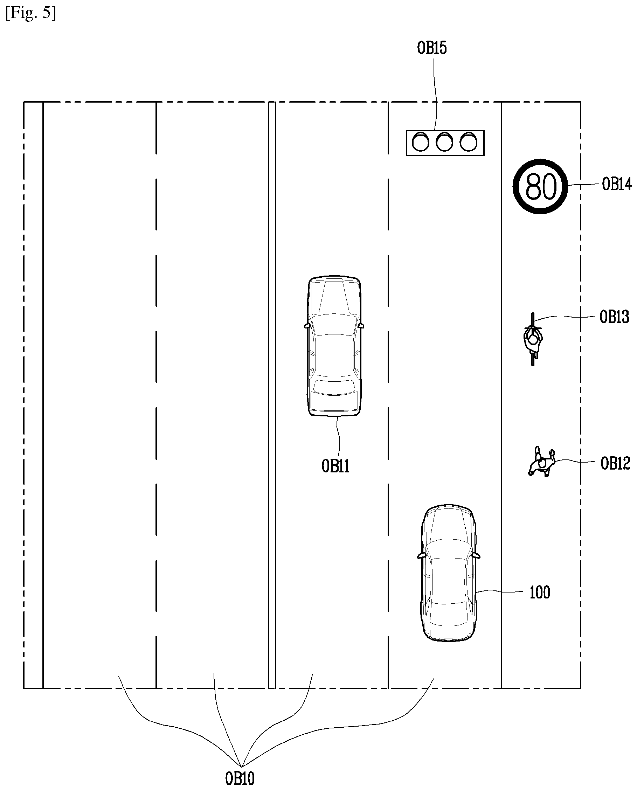

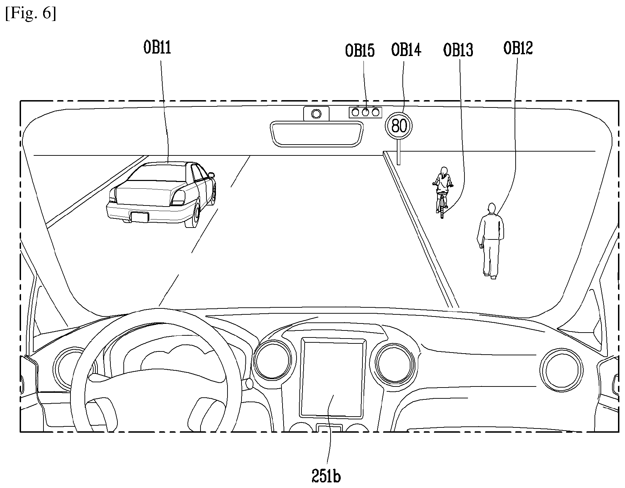

FIGS. 5 and 6 are views referenced to describe objects of the present disclosure.

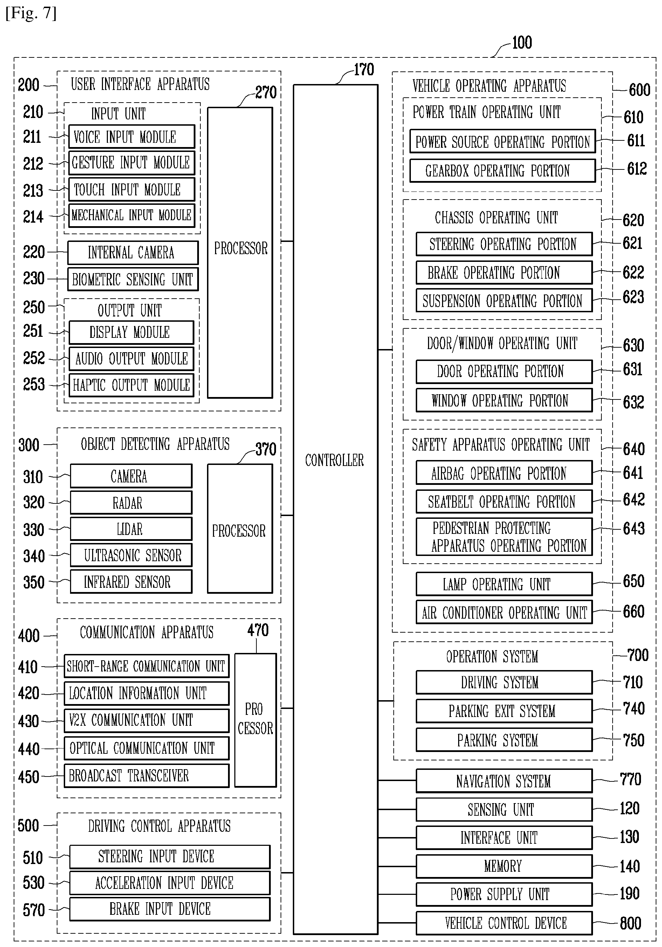

FIG. 7 is a block diagram referenced to describe a vehicle.

Referring to FIGS. 1 through 7, a vehicle 100 may include wheels turning by a driving force, and a steering apparatus 510 for adjusting a driving (ongoing, moving) direction of the vehicle 100.

The vehicle 100 may be an autonomous vehicle.

The vehicle 100 may be switched into an autonomous mode or a manual mode based on a user input.

For example, the vehicle may be converted from the manual mode into the autonomous mode or from the autonomous mode into the manual mode based on a user input received through a user interface apparatus 200.

The vehicle 100 may be switched into the autonomous mode or the manual mode based on driving environment information. The driving environment information may be generated based on object information provided from an object detecting apparatus 300.

For example, the vehicle 100 may be switched from the manual mode into the autonomous mode or from the autonomous module into the manual mode based on driving environment information generated in the object detecting apparatus 300.

In an example, the vehicle 100 may be switched from the manual mode into the autonomous mode or from the autonomous module into the manual mode based on driving environment information received through a communication apparatus 400.

The vehicle 100 may be switched from the manual mode into the autonomous mode or from the autonomous module into the manual mode based on information, data or signal provided from an external device.

When the vehicle 100 is driven in the autonomous mode, the autonomous vehicle 100 may be driven based on an operation system 700.

For example, the autonomous vehicle 100 may be driven based on information, data or signal generated in a driving system 710, a parking exit system 740 and a parking system 750.

When the vehicle 100 is driven in the manual mode, the autonomous vehicle 100 may receive a user input for driving through a driving control apparatus 500. The vehicle 100 may be driven based on the user input received through the driving control apparatus 500.

An overall length refers to a length from a front end to a rear end of the vehicle 100, a width refers to a width of the vehicle 100, and a height refers to a length from a bottom of a wheel to a roof. In the following description, an overall-length direction L may refer to a direction which is a criterion for measuring the overall length of the vehicle 100, a width direction W may refer to a direction that is a criterion for measuring a width of the vehicle 100, and a height direction H may refer to a direction that is a criterion for measuring a height of the vehicle 100.

As illustrated in FIG. 7, the vehicle 100 may include a user interface apparatus 200, an object detecting apparatus 300, a communication apparatus 400, a driving control apparatus 500, a vehicle operating apparatus 600, an operation system 700, a navigation system 770, a sensing unit 120, a vehicle interface unit 130, a memory 140, a controller 170 and a power supply unit 190.

The vehicle 100 may include more components in addition to components to be explained in this specification or may not include some of those components to be explained in this specification.

The user interface apparatus 200 is an apparatus for communication between the vehicle 100 and a user. The user interface apparatus 200 may receive a user input and provide information generated in the vehicle 100 to the user. The vehicle 200 may implement user interfaces (UIs) or user experiences (UXs) through the user interface apparatus 200.

The user interface apparatus 200 may include an input unit 210, an internal camera 220, a biometric sensing unit 230, an output unit 250 and a processor 270.

The user interface apparatus 200 may include more components in addition to components to be explained in this specification or may not include some of those components to be explained in this specification.

The input unit 200 may allow the user to input information. Data collected in the input unit 120 may be analyzed by the processor 270 and processed as a user's control command.

The input unit 210 may be disposed within the vehicle. For example, the input unit 200 may be disposed on one area of a steering wheel, one area of an instrument panel, one area of a seat, one area of each pillar, one area of a door, one area of a center console, one area of a headlining, one area of a sun visor, one area of a wind shield, one area of a window or the like.

The input unit 210 may include a voice input module 211, a gesture input module 212, a touch input module 213, and a mechanical input module 214.

The audio input module 211 may convert a user's voice input into an electric signal.

The converted electric signal may be provided to the processor 270 or the controller 170.

The voice input module 211 may include at least one microphone.

The gesture input module 212 may convert a user's gesture input into an electric signal. The converted electric signal may be provided to the processor 270 or the controller 170.

The gesture input module 212 may include at least one of an infrared sensor and an image sensor for detecting the user's gesture input.

The gesture input module 212 may detect a user's three-dimensional (3D) gesture input. To this end, the gesture input module 212 may include a light emitting diode outputting a plurality of infrared rays or a plurality of image sensors.

The gesture input module 212 may detect the user's 3D gesture input by a time of flight (TOF) method, a structured light method or a disparity method.

The touch input module 213 may convert the user's touch input into an electric signal. The converted electric signal may be provided to the processor 270 or the controller 170.

The touch input module 213 may include a touch sensor for detecting the user's touch input.

The touch input module 213 may be integrated with the display unit 251 so as to implement a touch screen. The touch screen may provide an input interface and an output interface between the vehicle 100 and the user.

The mechanical input module 214 may include at least one of a button, a dome switch, a jog wheel, and a jog switch. An electric signal generated by the mechanical input module 214 may be provided to the processor 270 or the controller 170.

The mechanical input module 214 may be arranged on a steering wheel, a center fascia, a center console, a cockpit module, a door and the like.

The internal camera 220 may acquire an internal image of the vehicle. The processor 270 may detect a user's state based on the internal image of the vehicle. The processor 270 may acquire information related to the user's gaze from the internal image of the vehicle. The processor 270 may detect a user gesture from the internal image of the vehicle.

The biometric sensing unit 230 may acquire the user's biometric information. The biometric sensing module 230 may include a sensor for detecting the user's biometric information and acquire fingerprint information and heart rate information regarding the user using the sensor. The biometric information may be used for user authentication.

The output unit 250 may generate an output related to a visual, audible or tactile signal.

The output unit 250 may include at least one of a display module 251, an audio output module 252 and a haptic output module 253.

The display module 251 may output graphic objects corresponding to various types of information.

The display module 251 may include at least one of a liquid crystal display (LCD), a thin film transistor-LCD (TFT LCD), an organic light-emitting diode (OLED), a flexible display, a three-dimensional (3D) display and an e-ink display.

The display module 251 may be inter-layered or integrated with a touch input module 213 to implement a touch screen.

The display module 251 may be implemented as a head up display (HUD). When the display module 251 is implemented as the HUD, the display module 251 may be provided with a projecting module so as to output information through an image which is projected on a windshield or a window.

The display module 251 may include a transparent display. The transparent display may be attached to the windshield or the window.

The transparent display may have a predetermined degree of transparency and output a predetermined screen thereon. The transparent display may include at least one of a transparent TFEL (Thin Film Electroluminescent), a transparent OLED (Organic Light-Emitting Diode), a transparent LCD (Liquid Crystal Display), a transmissive transparent display, and a transparent LED (Light Emitting Diode) display. The transparent display may have adjustable transparency.

Meanwhile, the user interface apparatus 200 may include a plurality of display modules 251a to 251g.

The display module 251 may be disposed on one area of a steering wheel, one area 521a, 251b, 251e of an instrument panel, one area 251d of a seat, one area 251f of each pillar, one area 251g of a door, one area of a center console, one area of a headlining or one area of a sun visor, or implemented on one area 251c of a windshield or one area 251h of a window.

The audio output module 252 converts an electric signal provided from the processor 270 or the controller 170 into an audio signal for output. To this end, the audio output module 252 may include at least one speaker.

The haptic output module 253 generates a tactile output. For example, the haptic output module 253 may vibrate the steering wheel, a safety belt, a seat 110FL, 110FR, 110RL, 110RR such that the user can recognize such output.

The processor 270 may control an overall operation of each unit of the user interface apparatus 200.

The user interface apparatus 200 may include a plurality of processors 270 or may not include any processor 270.

When the processor 270 is not included in the user interface apparatus 200, the user interface apparatus 200 may operate according to a control of a processor of another apparatus within the vehicle 100 or the controller 170.

Meanwhile, the user interface apparatus 200 may be called as a display apparatus for vehicle.

The user interface apparatus 200 may operate according to the control of the controller 170.

The object detecting apparatus 300 is an apparatus for detecting an object located at outside of the vehicle 100.

The object may be a variety of objects associated with driving (operation) of the vehicle 100.

Referring to FIGS. 5 and 6, an object O may include a traffic lane OB10, another vehicle OB11, a pedestrian OB12, a two-wheeled vehicle OB13, traffic signals OB14 and OB15, light, a road, a structure, a speed hump, a geographical feature, an animal and the like.

The lane OB01 may be a driving lane, a lane next to the driving lane or a lane on which another vehicle comes in an opposite direction to the vehicle 100. The lanes OB10 may be a concept including left and right lines forming a lane.

The another vehicle OB11 may be a vehicle which is moving around the vehicle 100. The another vehicle OB11 may be a vehicle located within a predetermined distance from the vehicle 100. For example, the another vehicle OB11 may be a vehicle which moves before or after the vehicle 100.

The pedestrian OB12 may be a person located near the vehicle 100. The pedestrian OB12 may be a person located within a predetermined distance from the vehicle 100. For example, the pedestrian OB12 may be a person located on a sidewalk or roadway.

The two-wheeled vehicle OB13 may refer to a vehicle (transportation facility) that is located near the vehicle 100 and moves using two wheels. The two-wheeled vehicle OB13 may be a vehicle that is located within a predetermined distance from the vehicle 100 and has two wheels. For example, the two-wheeled vehicle OB13 may be a motorcycle or a bicycle that is located on a sidewalk or roadway.

The traffic signals may include a traffic light OB15, a traffic sign OB14 and a pattern or text drawn on a road surface.

The light may be light emitted from a lamp provided on another vehicle. The light may be light generated from a streetlamp. The light may be solar light.

The road may include a road surface, a curve, an upward slope, a downward slope and the like.

The structure may be an object that is located near a road and fixed on the ground.

For example, the structure may include a streetlamp, a roadside tree, a building, an electric pole, a traffic light, a bridge and the like.

The geographical feature may include a mountain, a hill and the like.

Meanwhile, objects may be classified into a moving object and a fixed object. For example, the moving object may be a concept including another vehicle and a pedestrian. The fixed object may be a concept including a traffic signal, a road and a structure.

The object detecting apparatus 300 may include a camera 310, a radar 320, a lidar 330, an ultrasonic sensor 340, an infrared sensor 350 and a processor 370.

The object detecting apparatus 300 may further include other components in addition to the components described, or may not include some of the components described.

The camera 310 may be located on an appropriate portion outside the vehicle to acquire an external image of the vehicle. The camera 310 may be a mono camera, a stereo camera 310a, an AVM (Around View Monitoring) camera 310b, or a 360-degree camera.

For example, the camera 310 may be disposed adjacent to a front windshield within the vehicle to acquire a front image of the vehicle. Or, the camera 310 may be disposed adjacent to a front bumper or a radiator grill.

For example, the camera 310 may be disposed adjacent to a rear glass within the vehicle to acquire a rear image of the vehicle. Or, the camera 310 may be disposed adjacent to a rear bumper, a trunk or a tail gate.

For example, the camera 310 may be disposed adjacent to at least one of side windows within the vehicle to acquire a side image of the vehicle. Or, the camera 310 may be disposed adjacent to a side mirror, a fender or a door.

The camera 310 may provide an acquired image to the processor 370.

The radar 320 may include electric wave transmitting and receiving portions. The radar 320 may be implemented as a pulse radar or a continuous wave radar according to a principle of emitting electric waves. The radar 320 may be implemented by a Frequency Modulated Continuous Wave (FMCW) scheme or a Frequency Shift Keying (FSK) scheme according to a signal waveform in a continuous wave radar scheme.

The radar 320 may detect an object in a time of flight (TOF) manner or a phase-shift manner through the medium of electromagnetic waves, and detect a position of the detected object, a distance from the detected object and a relative speed with the detected object.

The radar 320 may be disposed on an appropriate position outside the vehicle for detecting an object which is located at a front, rear or side of the vehicle.

The lidar 330 may include laser transmitting and receiving portions. The lidar 330 may be implemented in a time of flight (TOF) manner or a phase-shift manner.

The lidar 330 may be implemented as a drive type or a non-drive type.

For the drive type, the lidar 330 may be rotated by a motor and detect object near the vehicle 100.

For the non-drive type, the lidar 330 may detect, through light steering, objects which are located within a predetermined range based on the vehicle 100. The vehicle 100 may include a plurality of non-drive type lidars 330.

The lidar 330 may detect an object in a time of flight (TOF) manner or a phase-shift manner through the medium of laser light, and detect a position of the detected object, a distance from the detected object and a relative speed with the detected object.

The lidar 330 may be disposed on an appropriate position outside the vehicle for detecting an object located at the front, rear or side of the vehicle.

The ultrasonic sensor 340 may include ultrasonic wave transmitting and receiving portions. The ultrasonic sensor 340 may detect an object based on an ultrasonic wave, and detect a position of the detected object, a distance from the detected object and a relative speed with the detected object.

The ultrasonic sensor 340 may be disposed on an appropriate position outside the vehicle for detecting an object located at the front, rear or side of the vehicle.

The infrared sensor 350 may include infrared light transmitting and receiving portions. The infrared sensor 340 may detect an object based on infrared light, and detect a position of the detected object, a distance from the detected object and a relative speed with the detected object.

The infrared sensor 350 may be disposed on an appropriate position outside the vehicle for detecting an object located at the front, rear or side of the vehicle.

The processor 370 may control an overall operation of each unit of the object detecting apparatus 300.

The processor 370 may detect an object based on an acquired image, and track the object. The processor 370 may execute operations, such as a calculation of a distance from the object, a calculation of a relative speed with the object and the like, through an image processing algorithm.

The processor 370 may detect an object based on a reflected electromagnetic wave which an emitted electromagnetic wave is reflected from the object, and track the object. The processor 370 may execute operations, such as a calculation of a distance from the object, a calculation of a relative speed with the object and the like, based on the electromagnetic wave.

The processor 370 may detect an object based on a reflected laser beam which an emitted laser beam is reflected from the object, and track the object. The processor 370 may execute operations, such as a calculation of a distance from the object, a calculation of a relative speed with the object and the like, based on the laser beam.

The processor 370 may detect an object based on a reflected ultrasonic wave which an emitted ultrasonic wave is reflected from the object, and track the object. The processor 370 may execute operations, such as a calculation of a distance from the object, a calculation of a relative speed with the object and the like, based on the ultrasonic wave.

The processor 370 may detect an object based on reflected infrared light which emitted infrared light is reflected from the object, and track the object. The processor 370 may execute operations, such as a calculation of a distance from the object, a calculation of a relative speed with the object and the like, based on the infrared light.

The object detecting apparatus 300 may include a plurality of processors 370 or may not include any processor 370. For example, each of the camera 310, the radar 320, the lidar 330, the ultrasonic sensor 340 and the infrared sensor 350 may include the processor in an individual manner.

When the processor 370 is not included in the object detecting apparatus 300, the object detecting apparatus 300 may operate according to the control of a processor of an apparatus within the vehicle 100 or the controller 170.

The object detecting apparatus 400 may operate according to the control of the controller 170.

The communication apparatus 400 is an apparatus for performing communication with an external device. Here, the external device may be another vehicle, a mobile terminal or a server.

The communication apparatus 400 may perform the communication by including at least one of a transmitting antenna, a receiving antenna, and radio frequency (RF) circuit and RF device for implementing various communication protocols.

The communication apparatus 400 may include a short-range communication unit 410, a location information unit 420, a V2X communication unit 430, an optical communication unit 440, a broadcast transceiver 450 and a processor 470.

The communication apparatus 400 may further include other components in addition to the components described, or may not include some of the components described.

The short-range communication unit 410 is a unit for facilitating short-range communications. Suitable technologies for implementing such short-range communications include BLUETOOTHTM, Radio Frequency IDentification (RFID), Infrared Data Association (IrDA), Ultra-WideBand (UWB), ZigBee, Near Field Communication (NFC), Wireless-Fidelity (Wi-Fi), Wi-Fi Direct, Wireless USB (Wireless Universal Serial Bus), and the like.

The short-range communication unit 410 may construct short-range area networks to perform short-range communication between the vehicle 100 and at least one external device.

The location information unit 420 is a unit for acquiring position information. For example, the location information unit 420 may include a Global Positioning System (GPS) module or a Differential Global Positioning System (DGPS) module.

The V2X communication unit 430 is a unit for performing wireless communications with a server (vehicle to infrastructure; V2I), another vehicle (vehicle to vehicle; V2V), or a pedestrian (vehicle to pedestrian; V2P). The V2X communication unit 430 may include an RF circuit capable of implementing a communication protocol with an infrastructure (V2I), a communication protocol between vehicles (V2V) and a communication protocol with a pedestrian (V2P).

The optical communication unit 440 is a unit for performing communication with an external device through the medium of light. The optical communication unit 440 may include a light-emitting diode for converting an electric signal into an optical signal and sending the optical signal to the exterior, and a photodiode for converting the received optical signal into an electric signal.

The light-emitting diode may be integrated with lamps provided on the vehicle 100.

The broadcast transceiver 450 is a unit for receiving a broadcast signal from an external broadcast managing entity or transmitting a broadcast signal to the broadcast managing entity via a broadcast channel. The broadcast channel may include a satellite channel, a terrestrial channel, or both. The broadcast signal may include a TV broadcast signal, a radio broadcast signal and a data broadcast signal.

The processor 470 may control an overall operation of each unit of the communication apparatus 400.

The communication apparatus 400 may include a plurality of processors 470 or may not include any processor 470.

When the processor 470 is not included in the communication apparatus 400, the communication apparatus 400 may operate according to the control of a processor of another device within the vehicle 100 or the controller 170.

Meanwhile, the communication apparatus 400 may implement a display apparatus for a vehicle together with the user interface apparatus 200. In this instance, the display apparatus for the vehicle may be referred to as a telematics apparatus or an Audio Video Navigation (AVN) apparatus.

The communication apparatus 400 may operate according to the control of the controller 170.

The driving control apparatus 500 is an apparatus for receiving a user input for driving.

In a manual mode, the vehicle 100 may be operated based on a signal provided by the driving control apparatus 500.

The driving control apparatus 500 may include a steering input device 510, an acceleration input device 530 and a brake input device 570.

The steering input device 510 may receive an input regarding a driving (ongoing) direction of the vehicle 100 from the user. The steering input device 510 is preferably configured in the form of a wheel allowing a steering input in a rotating manner.

The steering input device may also be configured in a shape of a touch screen, a touchpad or a button.

The acceleration input device 530 may receive an input for accelerating the vehicle 100 from the user. The brake input device 570 may receive an input for braking the vehicle 100 from the user. Each of the acceleration input device 530 and the brake input device 570 is preferably configured in the form of a pedal. The acceleration input device or the brake input device may also be configured in a shape of a touch screen, a touch pad or a button.

The driving control apparatus 500 may operate according to the control of the controller 170.

The vehicle operating apparatus 600 is an apparatus for electrically controlling operations of various devices within the vehicle 100.

The vehicle operating apparatus 600 may include a power train operating unit 610, a chassis operating unit 620, a door/window operating unit 630, a safety apparatus operating unit 640, a lamp operating unit 650, and an air-conditioner operating unit 660.

The vehicle operating apparatus 600 may further include other components in addition to the components described, or may not include some of the components described.

Meanwhile, the vehicle operating apparatus 600 may include a processor. Each unit of the vehicle operating apparatus 600 may individually include a processor.

The power train operating unit 610 may control an operation of a power train device.

The power train operating unit 610 may include a power source operating portion 611 and a gearbox operating portion 612.

The power source operating portion 611 may perform a control for a power source of the vehicle 100.

For example, upon using a fossil fuel-based engine as the power source, the power source operating portion 611 may perform an electronic control for the engine. Accordingly, an output torque and the like of the engine can be controlled. The power source operating portion 611 may adjust the engine output torque according to the control of the controller 170.

For example, upon using an electric energy-based motor as the power source, the power source operating portion 611 may perform a control for the motor. The power source operating portion 611 may adjust a rotating speed, a torque and the like of the motor according to the control of the controller 170.

The gearbox operating portion 612 may perform a control for a gearbox.

The gearbox operating portion 612 may adjust a state of the gearbox. The gearbox operating portion 612 may change the state of the gearbox into drive (forward) (D), reverse (R), neutral (N) or parking (P).

Meanwhile, when an engine is the power source, the gearbox operating portion 612 may adjust a locked state of a gear in the drive (D) state.

The chassis operating unit 620 may control an operation of a chassis device.

The chassis operating unit 620 may include a steering operating portion 621, a brake operating portion 622 and a suspension operating portion 623.

The steering operating portion 621 may perform an electronic control for a steering apparatus within the vehicle 100. The steering operating portion 621 may change a driving direction of the vehicle.

The brake operating portion 622 may perform an electronic control for a brake apparatus within the vehicle 100. For example, the brake operating portion 622 may control an operation of brakes provided at wheels to reduce speed of the vehicle 100.

Meanwhile, the brake operating portion 622 may individually control each of a plurality of brakes. The brake operating portion 622 may differently control braking force applied to each of a plurality of wheels.

The suspension operating portion 623 may perform an electronic control for a suspension apparatus within the vehicle 100. For example, the suspension operating portion 623 may control the suspension apparatus to reduce vibration of the vehicle 100 when a bump is present on a road.

Meanwhile, the suspension operating portion 623 may individually control each of a plurality of suspensions.

The door/window operating unit 630 may perform an electronic control for a door apparatus or a window apparatus within the vehicle 100.

The door/window operating unit 630 may include a door operating portion 631 and a window operating portion 632.

The door operating portion 631 may perform the control for the door apparatus. The door operating portion 631 may control opening or closing of a plurality of doors of the vehicle 100. The door operating portion 631 may control opening or closing of a trunk or a tail gate. The door operating portion 631 may control opening or closing of a sunroof.

The window operating portion 632 may perform the electronic control for the window apparatus. The window operating portion 632 may control opening or closing of a plurality of windows of the vehicle 100.

The safety apparatus operating unit 640 may perform an electronic control for various safety apparatuses within the vehicle 100.

The safety apparatus operating unit 640 may include an airbag operating portion 641, a seatbelt operating portion 642 and a pedestrian protecting apparatus operating portion 643.

The airbag operating portion 641 may perform an electronic control for an airbag apparatus within the vehicle 100. For example, the airbag operating portion 641 may control the airbag to be deployed upon a detection of a risk.

The seatbelt operating portion 642 may perform an electronic control for a seatbelt apparatus within the vehicle 100. For example, the seatbelt operating portion 642 may control passengers to be motionlessly seated in seats 110FL, 110FR, 110RL, 110RR using seatbelts upon a detection of a risk.

The pedestrian protecting apparatus operating portion 643 may perform an electronic control for a hood lift and a pedestrian airbag. For example, the pedestrian protecting apparatus operating portion 643 may control the hood lift and the pedestrian airbag to be open up upon detecting pedestrian collision.

The lamp operating portion 650 may perform an electronic control for various lamp apparatuses within the vehicle 100.

The air-conditioner operating unit 660 may perform an electronic control for an air conditioner within the vehicle 100. For example, the air-conditioner operating unit 660 may control the air conditioner to supply cold air into the vehicle when internal temperature of the vehicle is high.

The vehicle operating apparatus 600 may include a processor. Each unit of the vehicle operating apparatus 600 may individually include a processor.

The vehicle operating apparatus 600 may operate according to the control of the controller 170.

The operation system 700 is a system that controls various driving modes of the vehicle 100. The operation system 700 may be operated in the autonomous driving mode.

The operation system 700 may include a driving system 710, a parking exit system 740 and a parking system 750.

The operation system 700 may further include other components in addition to components to be described, or may not include some of the components to be described.

Meanwhile, the operation system 700 may include a processor. Each unit of the operation system 700 may individually include a processor.

Meanwhile, the operation system may be a sub concept of the controller 170 when it is implemented in a software configuration.

Meanwhile, the operation system 700 may be a concept including at least one of the user interface apparatus 200, the object detecting apparatus 300, the communication apparatus 400, the vehicle operating apparatus 600 and the controller 170.

The driving system 710 may perform driving of the vehicle 100.

The driving system 710 may receive navigation information from a navigation system 770, transmit a control signal to the vehicle operating apparatus 600, and perform driving of the vehicle 100.

The driving system 710 may receive object information from the object detecting apparatus 300, transmit a control signal to the vehicle operating apparatus 600 and perform driving of the vehicle 100.

The driving system 710 may receive a signal from an external device through the communication apparatus 400, transmit a control signal to the vehicle operating apparatus 600, and perform driving of the vehicle 100.

The parking exit system 740 may perform an exit of the vehicle 100 from a parking lot.

The parking exit system 740 may receive navigation information from the navigation system 770, transmit a control signal to the vehicle operating apparatus 600, and perform the exit of the vehicle 100 from the parking lot.

The parking exit system 740 may receive object information from the object detecting apparatus 300, transmit a control signal to the vehicle operating apparatus 600 and perform the exit of the vehicle 100 from the parking lot.

The parking exit system 740 may receive a signal from an external device through the communication apparatus 400, transmit a control signal to the vehicle operating apparatus 600, and perform the exit of the vehicle 100 from the parking lot.

The parking system 750 may perform parking of the vehicle 100.

The parking system 750 may receive navigation information from the navigation system 770, transmit a control signal to the vehicle operating apparatus 600, and park the vehicle 100.

The parking system 750 may receive object information from the object detecting apparatus 300, transmit a control signal to the vehicle operating apparatus 600 and park the vehicle 100.

The parking system 750 may receive a signal from an external device through the communication apparatus 400, transmit a control signal to the vehicle operating apparatus 600, and park the vehicle 100.

The navigation system 770 may provide navigation information. The navigation information may include at least one of map information, information regarding a set destination, path information according to the set destination, information regarding various objects on a path, lane information and current location information of the vehicle.

The navigation system 770 may include a memory and a processor. The memory may store the navigation information. The processor may control an operation of the navigation system 770.

The navigation system 770 may update prestored information by receiving information from an external device through the communication apparatus 400.

The navigation system 770 may be classified as a sub component of the user interface apparatus 200.

The sensing unit 120 may sense a status of the vehicle. The sensing unit 120 may include a posture sensor (e.g., a yaw sensor, a roll sensor, a pitch sensor, etc.), a collision sensor, a wheel sensor, a speed sensor, a tilt sensor, a weight-detecting sensor, a heading sensor, a gyro sensor, a position module, a vehicle forward/backward movement sensor, a battery sensor, a fuel sensor, a tire sensor, a steering sensor by a turn of a handle, a vehicle internal temperature sensor, a vehicle internal humidity sensor, an ultrasonic sensor, an illumination sensor, an accelerator position sensor, a brake pedal position sensor, and the like.

The sensing unit 120 may acquire sensing signals with respect to vehicle-related information, such as a posture, a collision, an orientation, a position (GPS information), an angle, a speed, an acceleration, a tilt, a forward/backward movement, a battery, a fuel, tires, lamps, internal temperature, internal humidity, a rotated angle of a steering wheel, external illumination, pressure applied to an accelerator, pressure applied to a brake pedal and the like.

The sensing unit 120 may further include an accelerator sensor, a pressure sensor, an engine speed sensor, an air flow sensor (AFS), an air temperature sensor (ATS), a water temperature sensor (WTS), a throttle position sensor (TPS), a TDC sensor, a crank angle sensor (CAS), and the like.

The vehicle interface unit 130 may serve as a path allowing the vehicle 100 to interface with various types of external devices connected thereto. For example, the vehicle interface unit 130 may be provided with a port connectable with a mobile terminal, and connected to the mobile terminal through the port. In this instance, the vehicle interface unit 130 may exchange data with the mobile terminal.

Meanwhile, the vehicle interface unit 130 may serve as a path for supplying electric energy to the connected mobile terminal. When the mobile terminal is electrically connected to the vehicle interface unit 130, the vehicle interface unit 130 supplies electric energy supplied from a power supply unit 190 to the mobile terminal according to the control of the controller 170.

The memory 140 is electrically connected to the controller 170. The memory 140 may store basic data for units, control data for controlling operations of units and input/output data. The memory 140 may be various storage apparatuses such as a ROM, a RAM, an EPROM, a flash drive, a hard drive, and the like in terms of hardware. The memory 140 may store various data for overall operations of the vehicle 100, such as programs for processing or controlling the controller 170.

The memory 140 may be integrated with the controller 170 or implemented as a sub component of the controller 170.

The controller 170 may control an overall operation of each unit of the vehicle 100. The controller 170 may be referred to as an Electronic Control Unit (ECU).

The power supply unit 190 may supply power required for an operation of each component according to the control of the controller 170. Specifically, the power supply unit 190 may receive power supplied from an internal battery of the vehicle, and the like.

At least one processor and the controller 170 included in the vehicle 100 may be implemented using at least one of application specific integrated circuits (ASICs), digital signal processors (DSPs), digital signal processing devices (DSPDs), programmable logic devices (PLDs), field programmable gate arrays (FPGAs), processors, controllers, micro controllers, microprocessors, and electric units performing other functions.

On the other hand, a vehicle described in the present disclosure may be provided with a vehicle lamp, and a sensor module may be provided in one region of the vehicle lamp.

Here, the sensor module described below may include at least one of the object detecting apparatus 300, the sensing unit 120, and the communication apparatus 400 described above, or sub-components (e.g., the camera 310, the radar 320, the lidar 330, the ultrasonic sensor 340, the infrared sensor 350, the short-range communication unit 410, the location information unit 420, the V2X communication unit 430, the optical communication unit 440, the broadcast transceiver 450, etc.) included therein.

In the present specification, a sensor (or a communication apparatus, a communication unit) capable of sensing surrounding information or receiving information from a communicable apparatus located in the vicinity will be referred to as a sensor module. This is because the sensor module may be made in the form of a single component and provided (mounted) on a portion of the vehicle lamp.

Hereinafter, the sensor module that can be provided on a portion of the vehicle lamp will be described in more detail with reference to the accompanying drawings.

The sensor module according to the present disclosure may be mounted on all types of lamps provided in the vehicle. In the present specification, a case where the sensor module is provided in a rear lamp will be described as an example, but the present disclosure is not limited thereto, and is also applicable to all types of lamps, such as a front lamp, a side lamp, an upper lamp, a lower lamp, and the like, that can be mounted on a vehicle.

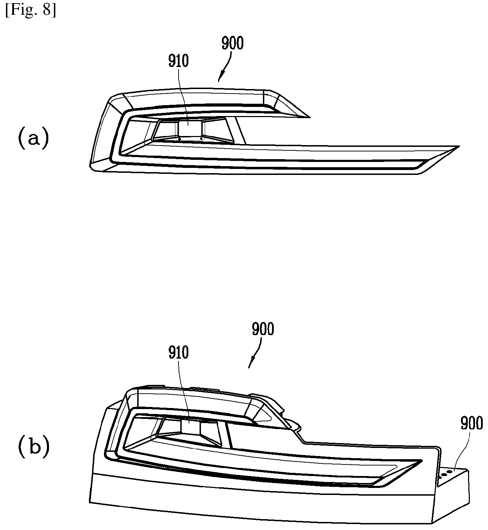

FIG. 8 is a conceptual view for explaining a vehicle lamp and the position of a sensor module provided therein.

Referring to FIG. 8, the sensor module 910 of the present disclosure may be provided (mounted) on a portion of a vehicle lamp 900 provided in the vehicle, as shown in (a) of FIG. 8. As shown in (b) of FIG. 8, the vehicle lamp 900 may be mounted on an exterior case of the vehicle (or a stand 920 on which the vehicle lamp is mounted).

For an example, the sensor module 910 may be mounted on a portion of the vehicle lamp 900, and for an example, the sensor module 910 may be mounted in a region except for a portion (e.g., a line lighting (Nexlide) or an NMR lighting) to which light is irradiated.

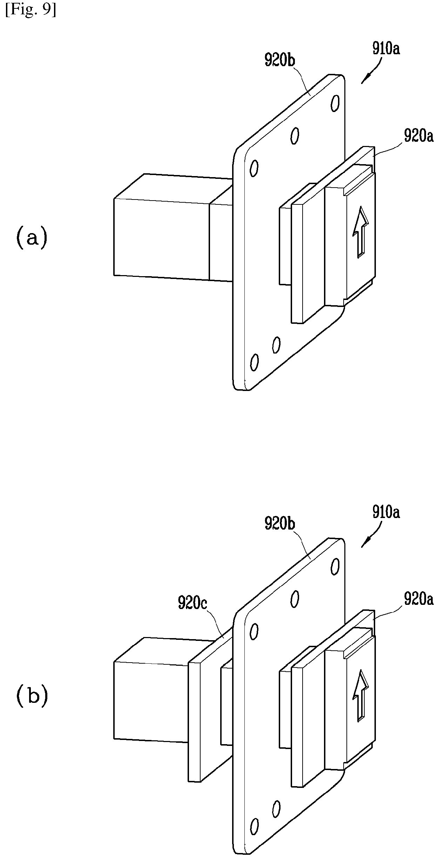

As such, the sensor module 910 that can be mounted on the vehicle lamp may be made of a plurality of printed circuit boards (or a plurality of layers), as shown in FIG. 9.

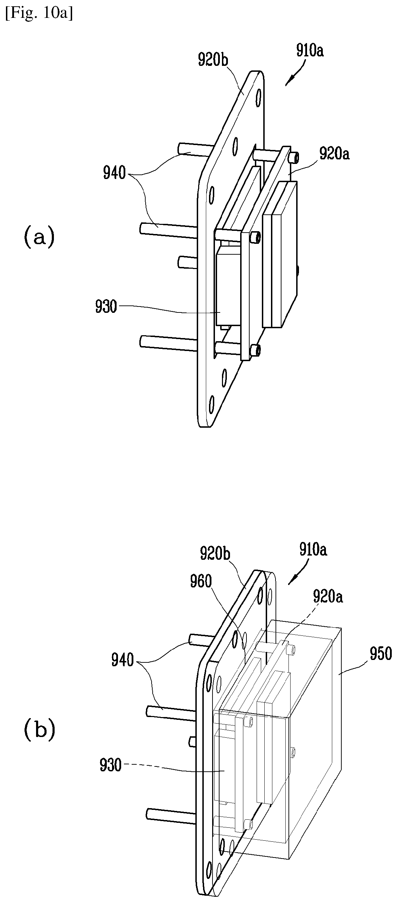

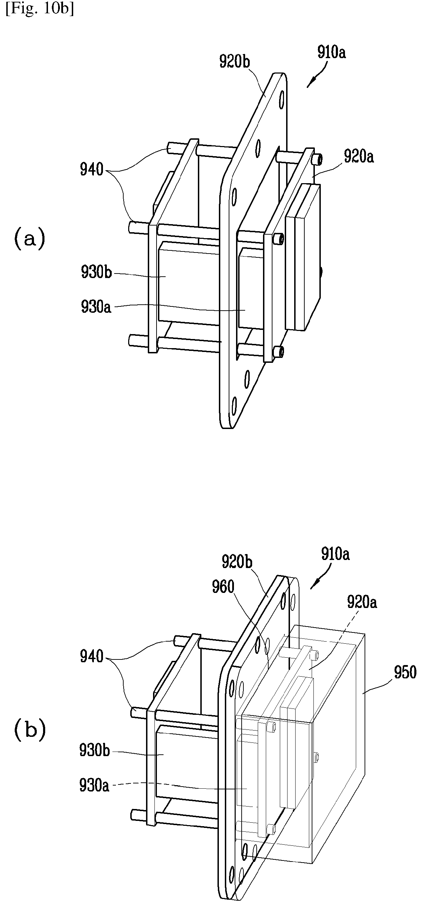

FIG. 9 is a conceptual view for explaining a sensor module that is part of an embodiment of the present disclosure, and FIGS. 10A and 10B are conceptual views for explaining the structures of a case where a sensor module consists of two printed circuit boards and a case where the sensor module consists of three printed circuit boards.

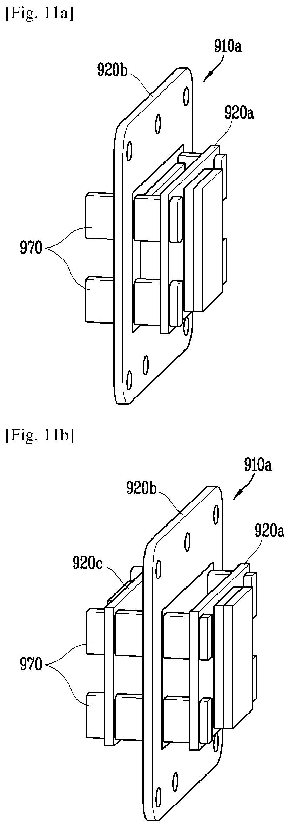

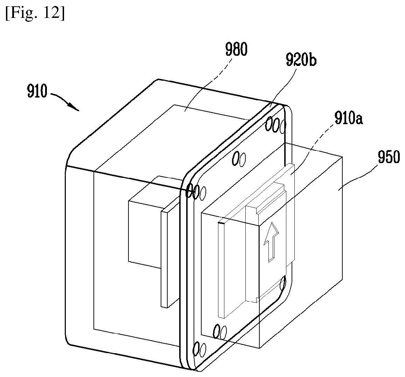

FIGS. 11A and 11B are conceptual views for explaining an example in which a support portion and a connector are integrally formed, and FIG. 12 is a conceptual view for explaining a cover and an electromagnetic wave absorber provided in the sensor module of the present disclosure.

The sensor module of the present disclosure may be made of two printed circuit boards, as shown in (a) of FIG. 9, or may be made of three printed circuit boards, as shown in (b) of FIG. 9.

First, referring to (a) of FIG. 9, the sensor module 910 of the present disclosure includes a sensor module 910a made of two printed circuit boards (or two layers).

The sensor module includes a first printed circuit board, a second printed circuit board disposed to face the first printed circuit board, and spaced apart by a first predetermined distance in one side direction of the first printed circuit board and a first support portion connecting the first printed circuit board and the second printed circuit board to be spaced apart from each other.

The sensor module 910a includes a first printed circuit board 920a, a second printed circuit board 920b disposed to face the first printed circuit board 920a, and disposed to be spaced apart by a first predetermined distance in one direction of the first printed circuit board 920a, and a first support portion 940a connecting the first printed circuit board 920a and the second printed circuit board 920b to be spaced apart from each other.

As illustrated in (a) of FIG. 10A, the first support portion 940a may be provided in plurality, and supports the first printed circuit board 920a and the second printed circuit board 920b to be spaced apart by a first predetermined distance and disposed in parallel to each other.

The first support portion 940a may be disposed at each corner portion of the first printed circuit board 920a.
the first and second printed circuit board are provided with an antenna unit, a signal processor, a communication unit and a power supply unit.

Here, the first and second printed circuit boards 920a, 920b include an antenna unit, a signal processor, a communication unit, and a power supply unit.

The first printed circuit board is provided with an antenna unit, and the second printed circuit board is provided with a signal processor, a communication unit and a power supply unit.

In a first embodiment, the first printed circuit board 920a may include an antenna unit, and the second printed circuit board 920b may include a signal processor, a communication unit, and a power supply unit.

The antenna unit provided in the first printed circuit board transmits a radar signal under the control of the signal processor, and receives a radar signal from the outside, and the signal processor provided in the second printed circuit board controls a signal to be transmitted from the antenna unit, and processes a signal received through the antenna unit, and the communication unit provided in the second printed circuit board transmits the signal processed by the signal processor to an ADAS system provided in a vehicle.

The antenna unit provided in the first printed circuit board 920a may transmit a radar signal under the control of the signal processor, and receive a radar signal from the outside, and the signal processor provided in the second printed circuit board 920b may control a signal to be transmitted from the antenna unit, and process a signal received through the antenna unit, and the communication unit provided in the second printed circuit board 920b may transmit a signal processed by the signal processor to an ADAS system provided in the vehicle.

The sensor module 910a may further include a first connector electrically connecting the first printed circuit board and the second printed circuit board.

As shown in FIG. 10A, the sensor module 910a may further include a first connector 930 that electrically connects the first printed circuit board 920a and the second printed circuit board 920b.

In FIG. 10A,, the first connector 930 is shown in the form of a fixed component, but is not limited thereto.

The first connector may be disposed in a flexible manner.

The second printed circuit board is disposed to have a larger area than that of the first printed circuit board.

As illustrated in FIGS. 9A and 10A,, the second printed circuit board 920b may be disposed to have an area larger than that of the first printed circuit board 920a.

At least one hole is disposed in a region of the second printed circuit board that does not overlap with the first printed circuit board.

In addition, as illustrated inFIG. 10A,, at least one hole 960 is disposed in an area of the second printed circuit board 920b that does not overlap with the first printed circuit board 920a.

Here, the non-overlapping region may denote a non-overlapping region generated when a size of the second printed circuit board 920b is larger than that of the first printed circuit board 920a while the first printed circuit board 920a and the second printed circuit board 920b are disposed to face each other.

As an example, the non-overlapping region may be defined to surround an overlapping region generated when the first printed circuit board 920a and the second printed circuit board 920b are projected in directions facing each other. This may be the case where the first printed circuit board 920a that is smaller in size is located at the center of the second printed circuit board 920b.

The second printed circuit board includes a first region overlapping with one surface of the first printed circuit board in a direction facing the first printed circuit board and a second region surrounding the first region.

At least one hole is disposed in the second region.

Specifically, the second printed circuit board 920b includes a first region overlapping with one surface of the first printed circuit board 920a in a direction facing the first printed circuit board 920a; and a second region that surrounds the first region.

Here, the first region denotes an overlapping region described above, and the second region may denote a non-overlapping region.

At least one hole 960 is disposed in the second region.

In addition, the sensor module 910a further includes a cover disposed to cover the first printed circuit board.

The cover is coupled to one surface of the second printed circuit board through at least one hole disposed in the second printed circuit board.

As illustrated inFIG. 10A,, the sensor module 910a further includes a cover 950 disposed to cover the first printed circuit board 920a.

The cover 950 is coupled to one surface of the second printed circuit board 920b through at least one hole 960 disposed in the second printed circuit board 920b.

One surface of the second printed circuit board 920b is a surface facing the first printed circuit board 920a.

As illustrated in FIG. 10A,, the cover 950 has an inner space disposed to cover the first printed circuit board 920a.

Accordingly, the first printed circuit board is disposed in an inner space of the cover.

In other words, the second printed circuit board includes a first region overlapping with one surface of the first printed circuit board in a direction facing the first printed circuit board; and a second region surrounding the first region.

An end portion of the cover is in close contact with the second region.

The second printed circuit board 920b includes a first region overlapping with one surface of the first printed circuit board 920a in a direction facing the first printed circuit board 920a and a second region that surrounds the first region.

An end portion of the cover 950 is in close contact with the second region. At least one hole may be disposed at an end portion of the cover 950 to correspond to (or overlap with) at least one hole disposed in the second printed circuit board 920b.

The second printed circuit board 920b and the cover 950 may be coupled to each other through a hole disposed in the second printed circuit board 920b and a hole disposed at an end portion of the cover 950. For an example, a coupling member may be inserted into the hole, or the second printed circuit board 920b and the cover 950 may be coupled to each other using a bolt and a nut.

Meanwhile, one surface of the second printed circuit board is a surface facing the first printed circuit board. Here, when the first printed circuit board 920a is located on the front surface of the second printed circuit board 920b, one surface of the second printed circuit board 920b denotes a front surface of the second printed circuit board.

One surface of the first printed circuit board 920a is a surface facing the second printed circuit board 920b, and the one surface of the first printed circuit board 920a denotes a rear surface of the first printed circuit board when the first printed circuit board 920a is located on a front surface of the second printed circuit board 920b.

Meanwhile, an electromagnetic wave absorber is mounted on the other surface of the second printed circuit board.

As illustrated in FIG. 12, an electromagnetic wave absorber 980 is mounted on the other surface of the second printed circuit board 920b.

The electromagnetic wave absorber may refer to a member that absorbs electromagnetic waves generated by a sensing module.

The electromagnetic wave absorber is coupled to the other surface of the second printed circuit board through at least one hole disposed in the second printed circuit board.

The electromagnetic wave absorber 980 is coupled to the other surface (e.g., rear surface) of the second printed circuit board 920b through at least one hole 960 disposed in the second printed circuit board 920b.

Meanwhile, as illustrated inFIG. 10A,, the first support portion 940 serves to connect the first printed circuit board 920a and the second printed circuit board 920b to be spaced apart from each other. Here, electrical signal transmission and reception between the first printed circuit board 920a and the second printed circuit board 920b may be carried out through the first connector 930.

On the other hand, as illustrated in FIG. 11A, in the sensor module 910a according to an embodiment of the present disclosure, the first support portion 940 and the first connector 930 may be integrally formed.

In this case, the first support portion may be disposed to transmit and receive electrical signals.

Accordingly, the first printed circuit board and the second printed circuit board transmit and receive electrical signals through the first support portion.

As illustrated in FIG. 11A, the first printed circuit board 920a and the second printed circuit board 920b may transmit and receive electrical signals through the first support portion 970.

In this case, the first connector 930 described with reference to FIG. 10A,may be omitted (not provided).

In addition, a second support portion is further provided on the other surface of the second printed circuit board.

As illustrated in FIG. 11A, a second support portion may be further provided on the other surface (e.g., rear surface) of the second printed circuit board 920b. Through the second support portion, the sensor module 910a may be coupled to a lamp module of the vehicle (or a vehicle lamp or a stand for mounting the vehicle lamp). A lamp module of a vehicle is coupled thereto through the second support portion.

In the above description, it has been described that the first printed circuit board 920a is provided with an antenna unit, and the second printed circuit board 920b is provided with a signal processor, a communication unit, and a power supply unit, but present disclosure is not limited thereto.

In the sensor module 910a according to another embodiment of the present disclosure, the first printed circuit board may include an antenna unit, a signal processor, and a communication unit, and the second printed circuit board may include a power supply unit.

In this case, the power supply unit may be provided in the second printed circuit board 920b having a large area, thereby having an advantage that the power supply unit having a large capacity can be mounted.

In the sensor module 910a according to still another embodiment of the present disclosure, the first printed circuit board may include an antenna unit and a signal processor, and the second printed circuit board may include a communication unit and a power supply unit.

In this case, the antenna and the signal processor may be provided on the first printed circuit board 920a, and the sensor module may be located at the outermost side to improve signal sensitivity when the sensor module is mounted on the vehicle lamp, and mounted on the printed circuit board separately from the communication unit to minimize signal noise.

As described above, according to the present disclosure, the antenna unit, the signal processor, the communication unit, and the power supply unit may be arranged in various ways on a plurality of printed circuit boards according to the design needs.

Up to now, a case in which the sensor module 910a consists of two printed circuit boards has been described, but the sensor module of the invention can include three printed circuit boards.

The sensor module 910 according to an embodiment of the present disclosure may include a sensor module 910b consisting of three printed circuit boards as illustrated in FIG. 9B.

The sensor module 910b may include a first printed circuit board, a second printed circuit board disposed to face the first printed circuit board, and spaced apart by a first predetermined distance in one direction of the first printed circuit board, a first support portion connecting the first printed circuit board and the second printed circuit board to be spaced apart from each other, a third printed circuit board disposed to face the second printed circuit board, and spaced apart by a second predetermined distance in the one direction of the second printed circuit board, and a second support portion connecting the second printed circuit board 920b and the third printed circuit board to be spaced apart from each other.

The sensor module 910b may include a first printed circuit board 920a, a second printed circuit board 920b disposed to face the first printed circuit board 920a, and spaced apart by a first predetermined distance in one direction of the first printed circuit board 920a, a first support portion 940a connecting the first printed circuit board 920a and the second printed circuit board 920b to be spaced apart from each other, a third printed circuit board 920c disposed to face the second printed circuit board 920b, and spaced apart by a second predetermined distance in the one direction of the second printed circuit board 920b, and a second support portion 940b connecting the second printed circuit board 920b and the third printed circuit board 920c to be spaced apart from each other.

The first through third printed circuit boards are provided with an antenna unit, a signal processor, a communication unit and a power supply unit.

Since the sensor module 910b consists of three printed circuit boards, the first to third printed circuit boards 920a, 920b, 920c may include an antenna unit, a signal processor, a communication unit, and a power supply unit.

For example, the first printed circuit board may include an antenna unit, and the second printed circuit board may include a signal processor, and the third printed circuit board may include a communication unit and a power supply unit.

The antenna unit provided in the first printed circuit board may transmit a radar signal under the control of the signal processor, and receive a radar signal from the outside.

The signal processor provided in the second printed circuit board may control a signal to be transmitted from the antenna unit, and process a signal received through the antenna unit.

The communication unit provided in the third printed circuit board may transmit a signal processed by the signal processor to an ADAS system provided in the vehicle.

In addition, the power supply unit may supply power to operate the components included in the sensor module 910b.

the sensor module 910b may further include a first connector electrically connecting the first printed circuit board and the second printed circuit board and a second connector electrically connecting the second printed circuit board and the third printed circuit board.

As illustrated in FIG. 10B, the sensor module 910b may further include a first connector 930a for electrically connecting the first printed circuit board 920a and the second printed circuit board 920b, and a second connector 930b for electrically connecting the second printed circuit board 920b and the third printed circuit board 920c.

As illustrated in FIG. 10B, it is illustrated that the first and second connectors 930a, 930b are provided in the form of a fixed component, but the present disclosure is not limited thereto.

At least one of the first and second connectors may be disposed in a flexible manner.

In other words, both of the first and second connectors may be disposed in a flexible manner, or only one of the first and second connectors may be disposed in a flexible manner.

On the other hand, the first printed circuit board and the third printed circuit board are disposed to have the same area, and the first printed circuit board and the third printed circuit board are disposed to overlap with each other in directions facing each other.

As illustrated in FIG. 10B, the first printed circuit board 920b and the third printed circuit board 920c may be disposed to have the same area. In addition, the first printed circuit board 920a and the third printed circuit board 920c may be disposed to overlap with each other in directions facing each other.

For example, the first printed circuit board 920a and the third printed circuit board 920c may be disposed to be symmetrical with respect to the second printed circuit board 920b.

As described above in the sensor module 910a consisting of two printed circuit boards, even in the case of the sensor module 910b consisting of three printed circuit boards, the second printed circuit board 920b may be disposed to have a larger area than that of the first and the third printed circuit boards 920a, 902c. That is, the second printed circuit board is disposed to have a larger area than that of the first and third printed circuit boards.

In addition, at least one hole is disposed in a region of the second printed circuit board that does not overlap with the first and third printed circuit boards.

As illustrated in FIG. 10B, at least one hole 960 may be disposed in a region of the second printed circuit board 920b that does not overlap with the first and third printed circuit boards 920a, 920c.

Specifically, the second printed circuit board includes a first region overlapping with one surface of the first printed circuit board in a direction facing the first printed circuit board; and a second region surrounding the first region.

At least one hole is disposed in the second region.

The second printed circuit board 920b includes a first region overlapping with one surface of the first printed circuit board 920a in a direction facing the first printed circuit board 920a and a second region that surrounds the first region.

As the first and third printed circuit boards 920a, 920c are disposed to face each other, the first region is an overlapping region that overlaps with one surface thereof, and the second region may denote a non-overlapping region that does not overlap therewith since the size of the second printed circuit board 920b is greater than that of the first and third printed circuit boards 920a, 920c.

When the first and third printed circuit boards are disposed at the center of the second printed circuit board 920b, the second region may be disposed to surround the first region.

At least one hole 960 is disposed in the second region, as illustrated in FIG. 10B.

The sensor module 910b further includes a cover disposed to cover the first printed circuit board.

The cover is coupled to one surface of the second printed circuit board through at least one hole disposed in the second printed circuit board.

The sensor module 910b further includes the cover 950 disposed to cover the first printed circuit board 920a.

The cover 950 is coupled to one surface of the second printed circuit board 920b through at least one hole 960 disposed in the second printed circuit board 920b.

One surface of the second printed circuit board 920b is a surface facing the first printed circuit board 920a.

As illustrated in FIG. 10B, the cover 950 has an inner space disposed to cover the first printed circuit board 920a.

Accordingly, the first printed circuit board 920a is disposed in an inner space of the cover 950.

The second printed circuit board includes a first region overlapping with one surface of the first printed circuit board in a direction facing the first printed circuit board; and a second region surrounding the first region.

An end portion of the cover is in close contact with the second region.

In other words, the second printed circuit board 920b includes a first region overlapping with one surface of the first printed circuit board 920a in a direction facing the first printed circuit board 920a and a second region that surrounds the first region.

An end portion of the cover 950 is in close contact with the second region. At least one hole may be disposed at an end portion of the cover 950 to correspond to (or overlap with) at least one hole disposed in the second printed circuit board 920b.

The second printed circuit board 920b and the cover 950 may be coupled to each other through a hole disposed in the second printed circuit board 920b and a hole disposed at an end portion of the cover 950. For an example, a coupling member may be inserted into the hole, or the second printed circuit board 920b and the cover 950 may be coupled to each other using a bolt and a nut.

Meanwhile, one surface of the second printed circuit board is a surface facing the first printed circuit board. Here, when the first printed circuit board 920a is located on the front surface of the second printed circuit board 920b, one surface of the second printed circuit board 920b denotes a front surface of the second printed circuit board.

One surface of the first printed circuit board 920a is a surface facing the second printed circuit board 920b, and the one surface of the first printed circuit board 920a denotes a rear surface of the first printed circuit board when the first printed circuit board 920a is located on a front surface of the second printed circuit board 920b.

Meanwhile, an electromagnetic wave absorber disposed to surround the third printed circuit board is mounted on the other surface of the second printed circuit board.

As illustrated in FIG. 12, an electromagnetic wave absorber 980 is mounted on the other surface of the second printed circuit board 920b even when the sensor module 910b consists of three printed circuit boards.

The electromagnetic wave absorber may refer to a member that absorbs electromagnetic waves generated by a sensing module.

The electromagnetic wave absorber is coupled to the other surface of the second printed circuit board through at least one hole disposed in the second printed circuit board.

The electromagnetic wave absorber 980 is coupled to the other surface (e.g., rear surface) of the second printed circuit board 920b through at least one hole 960 disposed in the second printed circuit board 920b.

In addition, the electromagnetic wave absorber 980 may be disposed with an inner space. Accordingly, the third printed circuit board 920c may be disposed in the inner space of the electromagnetic wave absorber 980.

A hole is disposed at an end portion of the electromagnetic wave absorber 980, and the electromagnetic wave absorber 980 may be coupled (adhered, attached) to the other surface of (e.g., a rear side, a surface facing the third printed circuit board) of the second printed circuit board 920b through the hole provided in the second printed circuit board 920b and the hole disposed at the end portion.

Meanwhile, the first support portion and the second support are disposed to transmit and receive electrical signals, and the first printed circuit board and the second printed circuit board transmit and receive electrical signals through the first support portion, and the second printed circuit board and the third printed circuit board transmit and receive electrical signals through the second support portion.

As illustrated in FIG. 10B, the first support portion 940a serves to connect the first printed circuit board 920a and the second printed circuit board 920b to be spaced apart from each other, and the second support portion 940b may serve to connect the second printed circuit board 920b and the third printed circuit board 920c to be spaced apart from each other.

Here, the electrical signal transmission and reception of the first printed circuit board 920a and the second printed circuit board 920b is carried out through the first connector 930a, and the electrical signal transmission and reception of the second printed circuit board 920b and the third printed circuit 920c is carried out through the second connector 930b.

On the other hand, as illustrated in FIG. 11B, in the sensor module 910b according to an example of the present disclosure, the first support portion 940a and the first connector 930a may be integrally formed, and the second support portion 940b and the second connector 930b may be integrally formed.

In this case, the first support 970a and the second support 970b may be disposed to transmit and receive electrical signals.

The first printed circuit board 920a and the second printed circuit board 920b may transmit and receive electrical signals through the first support 970a.

In addition, the second printed circuit board 920b and the third printed circuit board 920c may transmit and receive electrical signals through the second support 970b.

In this case, the first and second connectors 930a, 930b described with reference to FIG. 10B may be omitted (not provided).

In addition, a third support portion is further provided on the other surface of the third printed circuit board, and a lamp module of a vehicle is coupled thereto through the third support portion.

As illustrated in FIG. 11B, a support portion 970c may be further provided on the other surface of the third printed circuit board 920c (e.g., a surface in a direction opposite to a direction facing the third printed circuit board 920c, a rear surface). Through the third support portion 970c, the sensor module 910b may be combined with a lamp module (or a vehicle lamp or a stand for mounting the vehicle lamp) of the vehicle.

In the above description, it has been described that the first printed circuit board 920a is provided with an antenna unit, and the second printed circuit board 920b is provided with a signal processor, and the third printed circuit board 920c is provided with a communication unit, and a power supply unit, but present disclosure is not limited thereto.

In the sensor module 910b according to an embodiment of the present disclosure, the first printed circuit board may include an antenna unit, and the second printed circuit board may include a signal processor, and a communication unit, and the third printed circuit board may include a power supply unit.

In the sensor module 910b according to another embodiment of the present disclosure, the first printed circuit board may include an antenna unit and a signal processor, and the second printed circuit board may include a communication unit, and the third printed circuit board may include a power supply unit.

In the sensor module 910b according to still another embodiment of the present disclosure, the first printed circuit board may include an antenna unit and a signal processor, and the second printed circuit board may include a power supply unit, and the third printed circuit board may include a communication unit.

As described above, according to the present disclosure, the antenna unit, the signal processor, the communication unit, and the power supply unit may be arranged in various ways on a plurality of printed circuit boards according to the design needs.

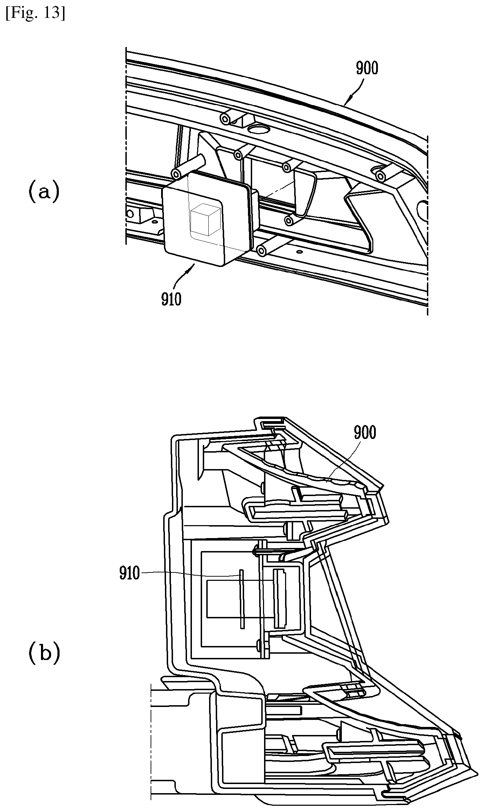

FIG. 13 is a conceptual view for explaining the position where the sensor module of the present disclosure is provided in the vehicle lamp.

Referring to (a) of FIG. 13, the sensor module 910 of the present disclosure may be mounted to be fixed to a portion of the vehicle lamp 900.

For example, as illustrated in (b) of FIG. 13, in the sensor module 910, at least part of the first printed circuit board 920a and the second printed circuit board 920b may be mounted to face the outside of the vehicle lamp 900.

For an example, the sensor module 910 may be coupled to the vehicle lamp 900 through at least one hole provided in the second printed circuit board 920b, or may be mounted on the vehicle lamp 900 through the second support portion (when consisting of two printed circuit boards) provided on the other surface (rear surface) of the second printed circuit board or the third support portion (when consisting of three printed circuit boards) provided on the other side (rear surface) of the third printed circuit board.

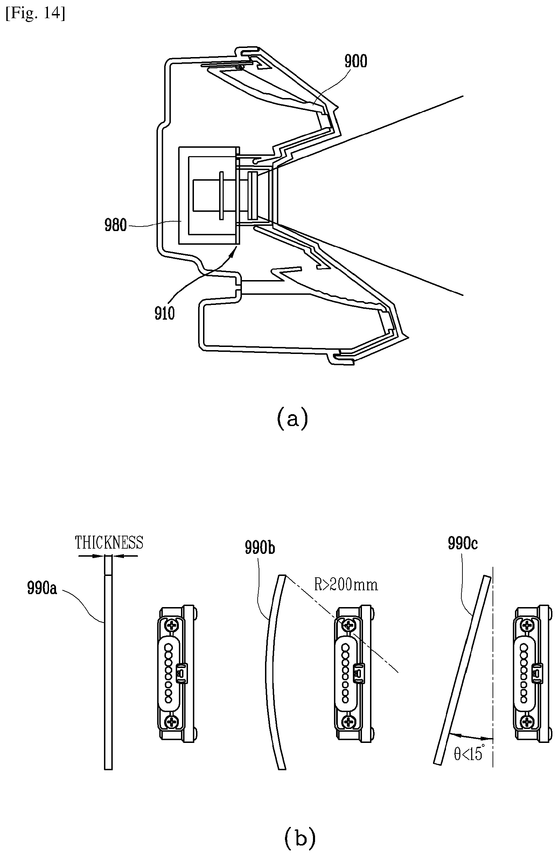

FIG. 14 is a conceptual view for explaining an outer lens applicable to a case where the sensor module of the present disclosure is provided in the vehicle lamp.

Referring to FIG. 14, even when the sensor module 910 is mounted on the vehicle lamp 900, in order to prevent the sensor module 910 from being directly exposed to the outside, the sensor module 910 or the vehicle lamp 900 may further include an outer lens 990a, 990b, 990c disposed to cover the sensor module 910.

As illustrated in FIG. 14(b), the outer lens may have various shapes according to its design purpose, and for an example, the outer lens may disposed to have a smaller thickness than a predetermined value, or may be disposed to have a predetermined curvature, or may be mounted inclined to have a predetermined angle in order to minimize the deflection of a signal or more effectively receive a signal in a desired direction.

The effects of a path providing device and a path providing method thereof according to the present disclosure will be described as follows.

First, the present disclosure may provide a new sensor module that can be mounted on a portion of a vehicle lamp.

Second, the present disclosure may provide a sensor module that can be mounted on the minimum area of the vehicle lamp.

Third, the present disclosure may provide a plurality of printed circuit boards (or layers, or PCBs) overlapping with each other, and components included in the sensor module may be distributively arranged on each printed circuit board, thereby minimizing an area occupied by the sensor module in the vehicle lamp.

The foregoing present disclosure may be implemented as codes (an application or software) readable by a computer on a medium written by the program. The control method of the above-described autonomous vehicle may be implemented by codes stored in a memory or the like.

The computer-readable media may include all kinds of recording devices in which data readable by a computer system is stored. Examples of the computer-readable media may include ROM, RAM, CD-ROM, magnetic tape, floppy disk, and optical data storage device, and the like, and also include a device implemented in the form of a carrier wave (for example, transmission via the Internet). In addition, the computer may include a processor or controller. Accordingly, the detailed description thereof should not be construed as restrictive in all aspects but considered as illustrative. The scope of the invention is defined by the appended claims.

## Claims

1. A sensor module (910), comprising:
a first printed circuit board (920a);
a second printed circuit board (920b) disposed to face the first printed circuit board, and spaced apart by a first predetermined distance in one side direction of the first printed circuit board (920a); and
a first support portion (940) connecting the first printed circuit board and the second printed circuit board to be spaced apart from each other,
wherein the first and second printed circuit board are provided with an antenna unit, a signal processor, a communication unit and a power supply unit
wherein the sensor module further comprises: a cover (950) disposed to cover the first printed circuit board, wherein the cover is coupled to one surface of the second printed circuit board through at least one hole disposed in the second printed circuit board, wherein the first printed circuit board is disposed in an inner space of the cover, and wherein the second printed circuit board comprises: a first region overlapping with one surface of the first printed circuit board in a direction facing the first printed circuit board; and a second region surrounding the first region, and wherein an end portion of the cover is in close contact with the second region,
wherein one surface of the second printed circuit board is a surface facing the first printed circuit board, wherein an electromagnetic wave absorber (980) is mounted on the other surface of the second printed circuit board, wherein the electromagnetic wave absorber is coupled to the other surface of the second printed circuit board through said at least one hole disposed in the second printed circuit board,
wherein the at least one hole is disposed in a region of the second printed circuit board that does not overlap with the first printed circuit board.

2. The sensor module of claim 1, wherein the first printed circuit board is provided with an antenna unit, and the second printed circuit board is provided with a signal processor, a communication unit and a power supply unit wherein preferably the antenna unit provided in the first printed circuit board transmits a radar signal under the control of the signal processor, and receives a radar signal from the outside, and the signal processor provided in the second printed circuit board controls a signal to be transmitted from the antenna unit, and processes a signal received through the antenna unit, and the communication unit provided in the second printed circuit board transmits the signal processed by the signal processor to an ADAS system provided in a vehicle.

3. The sensor module of claim 1 or 2, further comprising: a first connector (930) electrically connecting the first printed circuit board and the second printed circuit board, wherein preferably the first connector is disposed in a flexible manner, and/or wherein preferably the second printed circuit board is disposed to have a larger area than that of the first printed circuit board

4. The sensor module of any of the preceding claims, wherein the second printed circuit board comprises: the first region overlapping with one surface of the first printed circuit board in a direction facing the first printed circuit board; and the second region surrounding the first region, and wherein said at least one hole is disposed in the second region.

5. The sensor module of any of the preceding claims, wherein the first support portion is disposed to transmit and receive electrical signals, and the first printed circuit board and the second printed circuit board transmit and receive electrical signals through the first support portion, wherein preferably a second support portion is further provided on the other surface of the second printed circuit board, and a lamp module of a vehicle is coupled thereto through the second support portion, and/or wherein the first printed circuit board is provided with an antenna unit, a signal processor and a communication unit, and the second printed circuit board is provided with a power supply unit, or wherein preferably the first printed circuit board is provided with an antenna unit and a signal processor, and the second printed circuit board is provided with a communication unit and a power supply unit.

6. The sensor module of any of the preceding claims, wherein further comprising: a third printed circuit board (920c) disposed to face the second printed circuit board, and spaced apart by a second predetermined distance in the one side direction of the second printed circuit board; and a second support portion connecting the second printed circuit board and the third printed circuit board to be spaced apart from each other, wherein the first through third printed circuit boards are provided with an antenna unit, a signal processor, a communication unit and a power supply unit, wherein preferably the first printed circuit board is provided with an antenna unit, and the second printed circuit board is provided with a signal processor, and the third printed circuit board is provided with a communication unit and a power supply unit.

7. The sensor module of claim 6, wherein the antenna unit provided in the first printed circuit board transmits a radar signal under the control of the signal processor, and receives a radar signal from the outside, and the signal processor provided in the second printed circuit board controls a signal to be transmitted from the antenna unit, and processes a signal received through the antenna unit, and the communication unit provided in the third printed circuit board transmits the signal processed by the signal processor to an ADAS system provided in a vehicle, wherein preferably the sensor module further comprises: a first connector (930) electrically connecting the first printed circuit board and the second printed circuit board; and a second connector electrically connecting the second printed circuit board and the third printed circuit board,, wherein preferably the first connector and the second connector are disposed in a flexible manner

8. The sensor module of claim 6 or 7, wherein the first printed circuit board and the third printed circuit board are disposed to have the same area, and the first printed circuit board and the third printed circuit board are disposed to overlap with each other in directions facing each other, wherein preferably the second printed circuit board is disposed to have a larger area than that of the first and third printed circuit boards.

9. The sensor module of any of the claims 6 to 8, wherein said at least one hole is disposed in a region of the second printed circuit board that does not overlap with the first and third printed circuit boards, wherein the second printed circuit board comprises: the first region overlapping with one surface of the first printed circuit board in a direction facing the first printed circuit board; and the second region surrounding the first region, and wherein said at least one hole is disposed in the second region.

10. The sensor module of any of the claims 6 to 9, wherein one surface of the second printed circuit board is a surface facing the first printed circuit board, wherein preferably an electromagnetic wave absorber (980) disposed to surround the third printed circuit board is mounted on the other surface of the second printed circuit board, wherein the electromagnetic wave absorber is coupled to the other surface of the second printed circuit board through said at least one hole disposed in the second printed circuit board.

11. The sensor module of any of the claims 6 to 10, wherein the first support portion and the second support are disposed to transmit and receive electrical signals, and the first printed circuit board and the second printed circuit board transmit and receive electrical signals through the first support portion, and the second printed circuit board and the third printed circuit board transmit and receive electrical signals through the second support portion, wherein preferably a third support portion is further provided on the other surface of the third printed circuit board, and a lamp module of a vehicle is coupled thereto through the third support portion.

12. The sensor module of any of the claims 6 to 11, wherein the first printed circuit board is provided with an antenna unit, and the second printed circuit board is provided with a signal processor and a communication unit, and the third printed circuit board is provided with a power supply unit, or wherein the first printed circuit board is provided with an antenna unit and a signal processor, and the second printed circuit board is provided with a communication unit, and the third printed circuit board is provided with a power supply unit, or wherein the first printed circuit board is provided with an antenna unit and a signal processor, and the second printed circuit board is provided with a power supply unit, and the third printed circuit board is provided with a communication unit.

## Patentansprüche

1. Sensormodul (910), umfassend:
eine erste Leiterplatte (920a);
eine zweite Leiterplatte (920b), die der ersten Leiterplatte gegenüberliegend angeordnet ist und von dieser in einer seitlichen Richtung der ersten Leiterplatte (920a) um einen ersten vorgegebenen Abstand beabstandet ist; und
einen ersten Stützabschnitt (940), der die erste Leiterplatte und die zweite Leiterplatte so verbindet, dass sie voneinander beabstandet sind,
wobei die erste und die zweite Leiterplatte mit einer Antenneneinheit, einem Signalprozessor, einer Kommunikationseinheit und einer Stromversorgungseinheit versehen sind,
wobei das Sensormodul ferner umfasst: eine Abdeckung (950), die so angeordnet ist, dass sie die erste Leiterplatte abdeckt, wobei die Abdeckung über mindestens ein in der zweiten Leiterplatte angeordnetes Loch mit einer Oberfläche der zweiten Leiterplatte verbunden ist, wobei die erste Leiterplatte in einem Innenraum der Abdeckung angeordnet ist und wobei die zweite Leiterplatte umfasst: einen ersten Bereich, der sich in einer der ersten Leiterplatte zugewandten Richtung mit einer Oberfläche der ersten Leiterplatte überlappt; und einen zweiten Bereich, der den ersten Bereich umgibt, und wobei ein Endabschnitt der Abdeckung in engem Kontakt mit dem zweiten Bereich steht,
wobei eine Oberfläche der zweiten Leiterplatte eine der ersten Leiterplatte zugewandte Oberfläche ist, wobei ein Absorber (980) für elektromagnetische Wellen auf der anderen Oberfläche der zweiten Leiterplatte angebracht ist, wobei der Absorber für elektromagnetische Wellen über das mindestens eine in der zweiten Leiterplatte angeordnete Loch mit der anderen Oberfläche der zweiten Leiterplatte gekoppelt ist,
wobei das mindestens eine Loch in der zweiten Leiterplatte angeordnet ist,
wobei das mindestens eine Loch in einem Bereich der zweiten Leiterplatte angeordnet ist, der sich nicht mit der ersten Leiterplatte überschneidet.

2. Sensormodul nach Anspruch 1, wobei die erste Leiterplatte mit einer Antenneneinheit versehen ist und die zweite Leiterplatte mit einem Signalprozessor, einer Kommunikationseinheit und einer Stromversorgungseinheit versehen ist, wobei vorzugsweise die in der ersten Leiterplatte vorgesehene Antenneneinheit unter der Steuerung des Signalprozessors ein Radarsignal sendet und ein Radarsignal von außen empfängt, und der in der zweiten Leiterplatte vorgesehene Signalprozessor ein von der Antenneneinheit zu sendendes Signal steuert und ein über die Antenneneinheit empfangenes Signal verarbeitet, und die in der zweiten Leiterplatte vorgesehene Kommunikationseinheit das vom Signalprozessor verarbeitete Signal an ein in einem Fahrzeug vorgesehenes ADAS-System überträgt.

3. Sensormodul nach Anspruch 1 oder 2, das ferner umfasst: einen ersten Steckverbinder (930), der die erste Leiterplatte und die zweite Leiterplatte elektrisch verbindet, wobei der erste Steckverbinder vorzugsweise flexibel angeordnet ist und/oder wobei die zweite Leiterplatte vorzugsweise so angeordnet ist, dass sie eine größere Fläche als die erste Leiterplatte aufweist.

4. Sensormodul nach einem der vorstehenden Ansprüche, wobei die zweite Leiterplatte umfasst: einen ersten Bereich, der sich in einer der ersten Leiterplatte zugewandten Richtung mit einer Oberfläche der ersten Leiterplatte überlappt; und einen zweiten Bereich, der den ersten Bereich umgibt, und wobei das mindestens eine Loch im zweiten Bereich angeordnet ist.

5. Sensormodul nach einem der vorstehenden Ansprüche, wobei der erste Trägerabschnitt zum Senden und Empfangen elektrischer Signale ausgebildet ist und die erste Leiterplatte sowie die zweite Leiterplatte elektrische Signale über den ersten Trägerabschnitt senden und empfangen, wobei vorzugsweise ein zweiter Trägerabschnitt auf der anderen Oberfläche der zweiten Leiterplatte vorgesehen ist, und ein Lampenmodul eines Fahrzeugs über den zweiten Trägerabschnitt damit gekoppelt ist, und/oder wobei die erste Leiterplatte mit einer Antenneneinheit, einem Signalprozessor und einer Kommunikationseinheit versehen ist und die zweite Leiterplatte mit einer Stromversorgungseinheit versehen ist, oder wobei vorzugsweise die erste Leiterplatte mit einer Antenneneinheit und einem Signalprozessor versehen ist und die zweite Leiterplatte mit einer Kommunikationseinheit und einer Stromversorgungseinheit versehen ist.

6. Sensormodul nach einem der vorstehenden Ansprüche, wobei es ferner umfasst: eine dritte Leiterplatte (920c), die der zweiten Leiterplatte gegenüberliegend angeordnet ist und von dieser in einer seitlichen Richtung der zweiten Leiterplatte um einen zweiten vorbestimmten Abstand beabstandet ist; sowie einen zweiten Stützabschnitt, der die zweite Leiterplatte und die dritte Leiterplatte so verbindet, dass sie voneinander beabstandet sind, wobei die erste bis dritte Leiterplatte mit einer Antenneneinheit, einem Signalprozessor, einer Kommunikationseinheit und einer Stromversorgungseinheit versehen sind, wobei vorzugsweise die erste Leiterplatte mit einer Antenneneinheit, die zweite Leiterplatte mit einem Signalprozessor und die dritte Leiterplatte mit einer Kommunikationseinheit und einer Stromversorgungseinheit versehen ist.

7. Sensormodul nach Anspruch 6, wobei die in der ersten Leiterplatte vorgesehene Antenneneinheit unter der Steuerung des Signalprozessors ein Radarsignal sendet und ein Radarsignal von außen empfängt, und der in der zweiten Leiterplatte vorgesehene Signalprozessor ein von der Antenneneinheit zu sendendes Signal steuert und ein über die Antenneneinheit empfangenes Signal verarbeitet, und die in der dritten Leiterplatte vorgesehene Kommunikationseinheit das vom Signalprozessor verarbeitete Signal an ein in einem Fahrzeug vorgesehenes ADAS-System überträgt, wobei das Sensormodul vorzugsweise ferner umfasst: einen ersten Steckverbinder (930), der die erste Leiterplatte und die zweite Leiterplatte elektrisch verbindet; und einen zweiten Steckverbinder, der die zweite Leiterplatte und die dritte Leiterplatte elektrisch verbindet, wobei der erste Steckverbinder und der zweite Steckverbinder vorzugsweise flexibel angeordnet sind.

8. Sensormodul nach Anspruch 6 oder 7, wobei die erste Leiterplatte und die dritte Leiterplatte so angeordnet sind, dass sie dieselbe Fläche aufweisen, und die erste Leiterplatte und die dritte Leiterplatte so angeordnet sind, dass sie sich in zueinander gerichteten Richtungen überlappen, wobei vorzugsweise die zweite Leiterplatte so angeordnet ist, dass sie eine größere Fläche aufweist als die erste und die dritte Leiterplatte.

9. Sensormodul nach einem der Ansprüche 6 bis 8, wobei das mindestens eine Loch in einem Bereich der zweiten Leiterplatte angeordnet ist, der sich nicht mit der ersten und der dritten Leiterplatte überschneidet, wobei die zweite Leiterplatte umfasst: den ersten Bereich, der sich in einer der ersten Leiterplatte zugewandten Richtung mit einer Oberfläche der ersten Leiterplatte überschneidet; und den zweiten Bereich, der den ersten Bereich umgibt, und wobei das mindestens eine Loch in dem zweiten Bereich angeordnet ist.

10. Sensormodul nach einem der Ansprüche 6 bis 9, wobei eine Oberfläche der zweiten Leiterplatte eine der ersten Leiterplatte zugewandte Oberfläche ist, wobei vorzugsweise ein Absorber (980) für elektromagnetische Wellen, der so angeordnet ist, dass er die dritte Leiterplatte umgibt, auf der anderen Oberfläche der zweiten Leiterplatte angebracht ist, wobei der Absorber für elektromagnetische Wellen über das mindestens eine in der zweiten Leiterplatte angeordnete Loch mit der anderen Oberfläche der zweiten Leiterplatte gekoppelt ist.

11. Sensormodul nach einem der Ansprüche 6 bis 10, wobei der erste Stützabschnitt und der zweite Stützabschnitt so angeordnet sind, dass sie elektrische Signale senden und empfangen, und die erste Leiterplatte und die zweite Leiterplatte elektrische Signale über den ersten Stützabschnitt senden und empfangen, und die zweite Leiterplatte und die dritte Leiterplatte elektrische Signale über den zweiten Stützabschnitt senden und empfangen, wobei vorzugsweise ein dritter Stützabschnitt auf der anderen Oberfläche der dritten Leiterplatte vorgesehen ist und ein Lampenmodul eines Fahrzeugs über den dritten Stützabschnitt damit gekoppelt ist.

12. Sensormodul nach einem der Ansprüche 6 bis 11, wobei die erste Leiterplatte mit einer Antenneneinheit versehen ist und die zweite Leiterplatte mit einem Signalprozessor und einer Kommunikationseinheit versehen ist und die dritte Leiterplatte mit einer Stromversorgungseinheit versehen ist, oder wobei die erste Leiterplatte mit einer Antenneneinheit und einem Signalprozessor versehen ist und die zweite Leiterplatte mit einer Kommunikationseinheit versehen ist, und die dritte Leiterplatte mit einer Stromversorgungseinheit versehen ist, oder wobei die erste Leiterplatte mit einer Antenneneinheit und einem Signalprozessor versehen ist, die zweite Leiterplatte mit einer Stromversorgungseinheit versehen ist und die dritte Leiterplatte mit einer Kommunikationseinheit versehen ist.

## Revendications

1. Module de capteur (910), comprenant :
une première carte de circuit imprimé (920a) ;
une deuxième carte de circuit imprimé (920b) disposée en regard de la première carte de circuit imprimé, et espacée de celle-ci d'une première distance prédéterminée dans une direction latérale de la première carte de circuit imprimé (920a) ; et
une première partie de support (940) reliant la première carte de circuit imprimé et la deuxième carte de circuit imprimé de manière à ce qu'elles soient espacées l'une de l'autre,
dans lequel les première et deuxième cartes de circuit imprimé sont équipées d'une unité d'antenne, d'un processeur de signaux, d'une unité de communication et d'une unité d'alimentation électrique
dans lequel le module de capteur comprend en outre : un couvercle (950) agencé pour recouvrir la première carte de circuit imprimé, dans lequel le couvercle est couplé à une surface de la deuxième carte de circuit imprimé par l'intermédiaire d'au moins un trou disposé dans la deuxième carte de circuit imprimé, dans lequel la première carte de circuit imprimé est disposée dans un espace intérieur du couvercle, et dans lequel la deuxième carte de circuit imprimé comprend : une première région chevauchant une surface de la première carte de circuit imprimé dans une direction faisant face à la première carte de circuit imprimé ; et une deuxième région entourant la première région, et dans lequel une partie d'extrémité du couvercle est en contact étroit avec la deuxième région,
dans lequel une surface de la deuxième carte de circuit imprimé est une surface tournée vers la première carte de circuit imprimé, dans lequel un absorbeur d'ondes électromagnétiques (980) est monté sur l'autre surface de la deuxième carte de circuit imprimé, dans lequel l'absorbeur d'ondes électromagnétiques est couplé à l'autre surface de la deuxième carte de circuit imprimé par l'intermédiaire dudit au moins un trou disposé dans la deuxième carte de circuit imprimé,
dans lequel ledit au moins un trou est disposé dans une région de la deuxième carte de circuit imprimé qui ne chevauche pas la première carte de circuit imprimé.

2. Module de capteur selon la revendication 1, dans lequel la première carte de circuit imprimé est pourvue d'une unité d'antenne, et la deuxième carte de circuit imprimé est pourvue d'un processeur de signal, d'une unité de communication et d'une unité d'alimentation électrique, dans lequel, de préférence, l'unité d'antenne prévue dans la première carte de circuit imprimé émet un signal radar sous le contrôle du processeur de signal, et reçoit un signal radar provenant de l'extérieur, et le processeur de signaux prévu dans la deuxième carte de circuit imprimé commande un signal à émettre depuis l'unité d'antenne et traite un signal reçu par l'intermédiaire de l'unité d'antenne, et l'unité de communication prévue dans la deuxième carte de circuit imprimé transmet le signal traité par le processeur de signaux à un système ADAS prévu dans un véhicule.

3. Module de capteur selon la revendication 1 ou 2, comprenant en outre : un premier connecteur (930) reliant électriquement la première carte de circuit imprimé et la deuxième carte de circuit imprimé, dans lequel, de préférence, le premier connecteur est agencé de manière flexible, et/ou dans lequel, de préférence, la deuxième carte de circuit imprimé est agencée de manière à présenter une surface supérieure à celle de la première carte de circuit imprimé.

4. Module de capteur selon l'une quelconque des revendications précédentes, dans lequel la deuxième carte de circuit imprimé comprend : une première région recouvrant une surface de la première carte de circuit imprimé dans une direction tournée vers celle-ci ; et une deuxième région entourant la première région, et dans lequel ledit au moins un trou est disposé dans la deuxième région.

5. Module de capteur selon l'une quelconque des revendications précédentes, dans lequel la première partie de support est agencée pour émettre et recevoir des signaux électriques, et la première carte de circuit imprimé ainsi que la deuxième carte de circuit imprimé émettent et reçoivent des signaux électriques par l'intermédiaire de la première partie de support, dans lequel, de préférence, une deuxième partie de support est en outre prévue sur l'autre face de la deuxième carte de circuit imprimé, et un module d'éclairage d'un véhicule y est couplé par l'intermédiaire de la deuxième partie de support, et/ou dans lequel la première carte de circuit imprimé est pourvue d'une unité d'antenne, d'un processeur de signaux et d'une unité de communication, et la deuxième carte de circuit imprimé est pourvue d'une unité d'alimentation électrique, ou dans lequel, de préférence, la première carte de circuit imprimé est pourvue d'une unité d'antenne et d'un processeur de signaux, et la deuxième carte de circuit imprimé est pourvue d'une unité de communication et d'une unité d'alimentation électrique.

6. Module de capteur selon l'une quelconque des revendications précédentes, **caractérisé en ce qu'**il comprend en outre : une troisième carte de circuit imprimé (920c) disposée de manière à faire face à la deuxième carte de circuit imprimé, et espacée de celle-ci d'une deuxième distance prédéterminée dans la direction latérale de la deuxième carte de circuit imprimé ; et une deuxième partie de support reliant la deuxième carte de circuit imprimé et la troisième carte de circuit imprimé de manière à ce qu'elles soient espacées l'une de l'autre, dans lequel les première à troisième cartes de circuit imprimé sont équipées d'une unité d'antenne, d'un processeur de signal, d'une unité de communication et d'une unité d'alimentation électrique, dans lequel, de préférence, la première carte de circuit imprimé est équipée d'une unité d'antenne, la deuxième carte de circuit imprimé est équipée d'un processeur de signal, et la troisième carte de circuit imprimé est équipée d'une unité de communication et d'une unité d'alimentation électrique.

7. Module de capteur selon la revendication 6, dans lequel l'unité d'antenne prévue sur la première carte de circuit imprimé émet un signal radar sous le contrôle du processeur de signal et reçoit un signal radar provenant de l'extérieur, et le processeur de signal prévu sur la deuxième carte de circuit imprimé contrôle un signal devant être émis par l'unité d'antenne et traite un signal reçu par l'intermédiaire de l'unité d'antenne, et l'unité de communication prévue sur la troisième carte de circuit imprimé transmet le signal traité par le processeur de signal à un système ADAS prévu dans un véhicule, dans lequel, de préférence, le module de capteur comprend en outre : un premier connecteur (930) reliant électriquement la première carte de circuit imprimé et la deuxième carte de circuit imprimé ; et un deuxième connecteur reliant électriquement la deuxième carte de circuit imprimé et la troisième carte de circuit imprimé, dans lequel, de préférence, le premier connecteur et le deuxième connecteur sont agencés de manière flexible.

8. Module de capteur selon la revendication 6 ou 7, dans lequel la première carte de circuit imprimé et la troisième carte de circuit imprimé sont agencées de manière à présenter la même surface, et la première carte de circuit imprimé et la troisième carte de circuit imprimé sont agencées de manière à se chevaucher l'une l'autre dans des directions se faisant face, dans lequel, de préférence, la deuxième carte de circuit imprimé est agencée de manière à présenter une surface supérieure à celle des première et troisième cartes de circuit imprimé.

9. Module de capteur selon l'une quelconque des revendications 6 à 8, dans lequel ledit au moins un trou est disposé dans une zone de la deuxième carte de circuit imprimé qui ne chevauche pas les première et troisième cartes de circuit imprimé, dans lequel la deuxième carte de circuit imprimé comprend : une première zone chevauchant une surface de la première carte de circuit imprimé dans une direction tournée vers la première carte de circuit imprimé ; et une deuxième zone entourant la première zone, et dans lequel ledit au moins un trou est disposé dans la deuxième zone.

10. Module de capteur selon l'une quelconque des revendications 6 à 9, dans lequel une surface de la deuxième carte de circuit imprimé est une surface tournée vers la première carte de circuit imprimé, dans lequel, de préférence, un absorbeur d'ondes électromagnétiques (980) disposé de manière à entourer la troisième carte de circuit imprimé est monté sur l'autre surface de la deuxième carte de circuit imprimé, dans lequel l'absorbeur d'ondes électromagnétiques est couplé à l'autre surface de la deuxième carte de circuit imprimé par l'intermédiaire dudit au moins un trou disposé dans la deuxième carte de circuit imprimé.

11. Module de capteur selon l'une quelconque des revendications 6 à 10, dans lequel la première partie de support et le deuxième support sont agencés pour transmettre et recevoir des signaux électriques, et la première carte de circuit imprimé et la deuxième carte de circuit imprimé transmettent et reçoivent des signaux électriques par l'intermédiaire de la première partie de support, et la deuxième carte de circuit imprimé et la troisième carte de circuit imprimé transmettent et reçoivent des signaux électriques par l'intermédiaire de la deuxième partie de support, dans lequel, de préférence, une troisième partie de support est en outre prévue sur l'autre face de la troisième carte de circuit imprimé, et un module d'éclairage d'un véhicule y est couplé par l'intermédiaire de la troisième partie de support.

12. Module de capteur selon l'une quelconque des revendications 6 à 11, dans lequel la première carte de circuit imprimé est pourvue d'une unité d'antenne, et la deuxième carte de circuit imprimé est pourvue d'un processeur de signaux et d'une unité de communication, et la troisième carte de circuit imprimé est pourvue d'une unité d'alimentation électrique, ou dans lequel la première carte de circuit imprimé est pourvue d'une unité d'antenne et d'un processeur de signaux, et la deuxième carte de circuit imprimé est pourvue d'une unité de communication, et la troisième carte de circuit imprimé est équipée d'une unité d'alimentation, ou dans lequel la première carte de circuit imprimé est équipée d'une unité d'antenne et d'un processeur de signaux, et la deuxième carte de circuit imprimé est équipée d'une unité d'alimentation, et la troisième carte de circuit imprimé est équipée d'une unité de communication.
